(19) Europäisches Patentamt

European Patent Office

Office européen des brevets

(11) **EP 1 702 905 A1**

(12) **EUROPEAN PATENT APPLICATION**

(43) Date of publication:
20.09.2006 Bulletin 2006/38

(51) Int Cl.:
*C04B 35/493* (2006.01)     *H01L 41/08* (2006.01)

(21) Application number: 06251240.5

(22) Date of filing: 08.03.2006

(84) Designated Contracting States:
AT BE BG CH CY CZ DE DK EE ES FI FR GB GR
HU IE IS IT LI LT LU LV MC NL PL PT RO SE SI
SK TR
Designated Extension States:
AL BA HR MK YU

(30) Priority: 09.03.2005 JP 2005066227
25.03.2005 JP 2005089582
25.03.2005 JP 2005089592
30.08.2005 JP 2005249432

(71) Applicant: TDK Corporation
Tokyo 103-8272 (JP)

(72) Inventors:
• Iezumi, Kumiko
c/o TDK Corporation
Tokyo 103-8272 (JP)
• Tsukada, Takeo
c/o TDK Corporation
Tokyo 103-8272 (JP)
• Inoue, Masayoshi
c/o TDK Corporation
Tokyo 103-8272 (JP)

• Yamazaki, Jyunichi
c/o TDK Corporation
Tokyo 103-8272 (JP)
• Nanao, Masaru
c/o TDK Corporation
Tokyo 103-8272 (JP)
• Furukawa, Masahito
c/o TDK Corporation
Tokyo 103-8272 (JP)
• Sakamoto, Hideya
c/o TDK Corporation
Tokyo 103-8272 (JP)
• Sakamoto, Norimasa
c/o TDK Corporation
Tokyo 103-8272 (JP)

(74) Representative: Wise, Stephen James et al
c/o RAWORTH, MOSS & COOK,
Raworth House,
36 Sydenham Road
Croydon,
Surrey CR0 2EF (GB)

(54) **Piezoelectric ceramic composition, production method thereof, piezoelectric element and fabrication method thereof**

(57) A piezoelectric ceramic composition has as a chief ingredient a composite oxide that has Pb, Ti and Zr as constituent elements. It contains as a first accessory ingredient at least one element selected from the group consisting of Mn, Co, Cr, Fe and Ni in an amount of 0.2 mass% or less excluding 0 mass% in terms of an oxide. As the first accessory ingredient, at least one species selected from the ingredients represented by $CuO_x$, wherein $x \geq 0$, can be adopted. In this case, the content of the first accessory ingredient is 3.0 mass% or less excluding 0 mass%. The piezoelectric ceramic composition is fired under reducing and firing conditions. The reducing and firing conditions include a firing temperature in the range of 800°C to 1200°C and an oxygen partial pressure in the range of $1 \times 10^{-10}$ to $1 \times 10^{-6}$ atm., for example.

EP 1 702 905 A1

# EP 1 702 905 A1

**Description**

BACKGROUND OF THE INVENTION

Field of the Invention:

The present invention relates to a piezoelectric ceramic composition suitable for a piezoelectric layer of a piezoelectric element including actuators, piezoelectric buzzers, sounding bodies, sensors, etc., to a production method thereof and to a piezoelectric element using the composition.

Description of the Prior Art:

Actuators utilizing as a mechanical drive source a displacement generated by the piezoelectric effect, for example, are small in power consumption and calorific power, good in response, can be made small in size and lightweight and have other such advantages and, therefore, have been utilized in a wide range of fields.

A piezoelectric ceramic composition used in the actuators of this kind is required to have excellent piezoelectric characteristics, particularly a large piezoelectric strain constant. As a piezoelectric ceramic component satisfying this requirement, a three-element-based piezoelectric ceramic composition comprising lead titanate ($PbTiO_3$), lead zirconate ($PbZrO_3$) and lead zinc niobate [$Pb(Zn_{1/3}Nb_{2/3})O_3$], a piezoelectric ceramic composition having part of Pb in the three-element-based piezoelectric ceramic composition substituted with Sr, Ba, Ca, etc. and other such compositions have been developed.

However, it is required that the conventional piezoelectric ceramic compositions be fired at relatively high temperature. Since the calcination is performed in an oxidizing atmosphere, in the case of multilayer actuators, etc., it is required to use a precious metal (Pt, Pd, etc., for example) having a high melting point and not oxidized when being fired in an oxidizing atmosphere, resulting in high cost, thereby preventing a fabricated piezoelectric element from being reduced in cost.

Under these circumstances, the present inventors proposed in JP-A 2004-137106 a three-element-based piezoelectric ceramic composition added with an accessory ingredient including at least one element selected from the group consisting of Fe, Co, Ni and Cu and a second accessory ingredient including at least one element selected from the group consisting of Sb, Nb and Ta to enable low temperature calcination, with the result that an inexpensive material, such as Ag-Pd alloy, can be used for internal electrodes.

By adding the first accessory ingredient including at least one element selected from the group consisting of Fe, Co, Ni and Cu and the second accessory ingredient including at least one element selected from the group consisting of Sb, Nb and Ta to the aforementioned three-element-based piezoelectric ceramic composition or the piezoelectric ceramic composition having part of Pb in the three-element-based piezoelectric ceramic composition substituted with Sr, Ba, Ca, etc. in the prior art, it is possible to realize a piezoelectric ceramic composition having a large piezoelectric strain constant, made extremely precise without impairing the various piezoelectric characteristics even when being fired at low temperature and enhanced in mechanical strength and to provide a piezoelectric element having the piezoelectric layer comprising the piezoelectric ceramic composition.

Incidentally, when a cheaper metal (Cu, Ni, etc., for example) is used as an electrode material, the electrode material will be oxidized to impair the conductivity thereof in case calcination is performed in an oxidizing atmosphere (in the air, for example) even at low temperature. This is disadvantageous.

In order to eliminate the disadvantage, calcination has to be performed in a reduction atmosphere of a low oxygen partial pressure (the oxygen partial pressure is around $1 \times 10^{-9}$ to $1 \times 10^{-6}$ atm.). When the calcination has been performed in the reduction atmosphere, however, since a fired body obtained contains many oxygen voids in comparison with a sintered body fired in the air, the insulation resistance at high temperatures (100°C or more) is particularly lowered to lower the insulated life of a product. There are many cases where the temperature range of 100°C to 200°C is also the operation standard temperature of products, and the lowering of the insulation resistance and insulated life in this temperature range considerably deteriorates the reliability of the products. This is seriously problematic.

From the standpoint of the above, in the technology of the prior art, while the addition of the first and second accessory ingredients enables the value per se of the electrical resistance at high temperatures to be improved as compared with no addition, lowering of the electrical resistance value is improved little as compared with that at normal temperatures. A further improvement in electrical resistance at high temperatures is being needed.

The present invention has been proposed in view of the conventional state of affairs. An object of the present invention is to provide a piezoelectric ceramic composition and a production method thereof, in which inexpensive metals, such as Cu, Ni, etc., can be used as electrode materials and the electrical resistance can be improved, with the excellent piezoelectric characteristics maintained. Another object thereof is to provide an inexpensive piezoelectric element excellent in reliability.

2

To attain the above objects, the present inventors have continued making various studies over a long period of time and consequently, first of all, it has come to a conclusion that addition of a small amount of any one of Mn, Co, Cr, Fe and Ni enabled the electrical resistance to be specifically improved and the lowering of the electromechanical coupling factor kr to be suppressed.

SUMMARY OF THE INVENTION

The present invention provides as the first aspect thereof a piezoelectric ceramic composition comprising as a chief ingredient a composite oxide that has Pb, Ti and Zr as constituent elements and as a first accessory ingredient at least one element selected from the group consisting of Mn, Co, Cr, Fe and Ni in an amount of 0.2 mass% or less excluding 0 mass% in terms of an oxide.

By adding as the accessory ingredient a small amount of at least one element selected from the group consisting of Mn, Co, Cr, Fe and Ni, a decrease in electrical resistance at high temperatures can be suppressed, with excellent piezoelectric characteristics maintained. Though a detailed mechanism of the reason for it has not been elucidated, in fact the insulated life is remarkably enhanced. It is at a level satisfying the reliability standards required for automobile parts, for example. A decrease in the electromechanical coupling factor kr at this time is at a level not regarded as being problematic.

When the amount of the first accessory ingredient added is excessive, the piezoelectric characteristics (electromechanical coupling factor kr, for example) are lowered, and the degree of improvement of the electrical resistance is also lowered. In the present invention, therefore, the amount of the first accessory ingredient added is set to be 0.2 mass% or less.

Further, studies have been made on the addition of Fe, Co or Ni in the prior art. In the prior art, however, the added amount is more than that prescribed in the present invention, and calcination under the reducing and firing conditions is not taken into consideration. Furthermore, the prior art does not recognize at all that addition of a small amount is effective for suppressing a decrease of the electrical resistance from that at normal temperatures and that the insulation resistance can be improved in calcination in a reduction atmosphere.

Secondly, it has come to conclusion that the addition of the ingredient represented by CuOx ($x \geq 0$), such as Cu, $Cu_2O$, CuO, etc., in the calcination in the reduction atmosphere enables the insulated life to be specifically improved and the decrease in electromechanical coupling factor kr to be suppressed.

The present invention, therefore, provides as the eleventh aspect thereof a piezoelectric ceramic composition fired under reducing and firing conditions and comprising as a chief ingredient a composite oxide that has Pb, Ti and Zr as constituent elements and as a first accessory ingredient at least one species selected from ingredients represented by $CuO_x$ ($x \geq 0$) in an amount of 3.0 mass% or less excluding 0 mol% in terms of CuO.

By adding as the accessory ingredient an ingredient represented by $CuO_x$ ($x \geq 0$), a decrease in insulation resistance at high temperatures can be suppressed, and the insulated life (hot load life) can simultaneously be improved. Though a detailed mechanism of the reason for it has not been elucidated, in fact the insulated life is remarkably enhanced by the addition of $CuO_x$ ($x \geq 0$). It is at a level satisfying the reliability standards required for automobile parts, for example. A decrease in the electromechanical coupling factor kr at this time is at a level not regarded as being problematic.

Incidentally, studies on the addition of Cu have been made in the prior art. In the prior art, however, Cu is merely one of the materials listed together with Fe, Co, Ni, etc. It is not recognized at all that the insulation resistance or hot load life is improved in the calcination in the reduction atmosphere.

Thirdly, it has come to knowledge that the existence of Cu in a piezoelectric body layer in some form enables a decrease in electrical resistance at high temperatures to be improved.

The present invention provides as the twentieth aspect thereof a piezoelectric element comprising a plurality of piezoelectric body layers each having as a chief ingredient a composite oxide that has Pb, Ti and Zr as constituent elements and containing at least one species selected from ingredients represented by $CuO_x$ ($x \geq 0$), and internal electrode layers each intervening between adjacent piezoelectric body layers and containing Cu.

In the piezoelectric element equipped with an internal electrode layer containing Cu, when the piezoelectric body layer contains $CuO_x$, a decrease in electrical resistance at high temperatures (100°C to 200°C) is improved. A decrease in the electromechanical coupling factor kr at this time is at a level not regarded as being problematic. Though the detailed reason for the improvement has not yet been elucidated, it is the fact having been confirmed through the experiments that the presence of Cu enables the decrease in electrical resistance at high temperatures to be remarkably improved.

To cause Cu to exist in the piezoelectric body layer, Cu contained in the internal electrode layer may be diffused or separate Cu may be added to the raw material composition for the piezoelectric body layer. This is prescribed in the production method according to the present invention. To be specific, a method for the production of a multilayer piezoelectric element comprising a plurality of piezoelectric body layers each having as a chief ingredient a composite oxide that has Pb, Ti and Zr as constituent elements and internal electrode layers intervening between adjacent piezoelectric body layers and containing Cu comprises performing calcination under reducing and firing conditions to diffuse the Cu contained in the internal electrode layers into the piezoelectric body layers or comprises adding species containing Cu to a raw material matrix composition for the piezoelectric body layers and performing calcination under reducing and firing conditions. In either case, by performing calcination under reducing and firing conditions, an ingredient represented by $CuO_x$ ($x \geq 0$) comes to be contained in the piezoelectric body layers.

Fourthly, it has come to knowledge that the maldistribution of Cu in the grain boundaries enables the insulation property of the grain boundaries to be heightened to contribute to improvement in acceleration voltage load property while Cu segregation in granular form is undesirable and that the maldistribution changes the composition in the grains little not to deteriorate the piezoelectric strain property.

The present invention provides as the thirty-second aspect thereof a piezoelectric ceramic composition containing a composite oxide that has Pb, Ti and Zr as constituent elements and having a structure that has Cu distributed unevenly in grain boundaries and as the thirty-seventh aspect thereof a piezoelectric element comprising a plurality of piezoelectric body layers each formed of a piezoelectric ceramic composition containing a composite oxide that has Pb, Ti and Zr as constituent elements and having a structure that has Cu distributed unevenly in grain boundaries, and internal electrode layers each intervening between adjacent piezoelectric body layers and containing Cu.

When Cu is used as an electrode material, it is concerned that the electrode material even when fired at low temperatures segregates to adversely affect the characteristics. Attempts have heretofore been made on an improvement in the prior art with respect to the segregation of Cu. There is proposed, for example, a multilayer piezoelectric element having dielectric ceramic layers and electrode layers alternately stacked, in which the electrode layer is formed mainly of a conductive base metal material having a larger standard Gibbs free energy of a metal oxide at the firing temperature than the ceramic material constituting the dielectric ceramic layer and in which part of the dielectric ceramic layer sandwiched between the adjacent positive and negative electrode layers has no segregation of a material including the conductive base metal material. According to the multilayer piezoelectric element, the characteristics of the dielectric ceramic layer can sufficiently be exhibited because there is no segregation of the material including the conductive base metal material in the part of the dielectric ceramic layer sandwiched between the adjacent positive and negative electrode layers.

However, the subsequent studies made by the present inventors have revealed that it cannot be judged only from the presence or absence of the segregation in granular form whether the performance of a piezoelectric element is good or not. It has been found that the absence of segregation in granular form is not always associated with the exhibition of good characteristics (acceleration voltage load life, etc.).

In the multilayer piezoelectric element mentioned above, CuO is fundamentally used as an electrode material, reduced to Cu in the so-called metalizing process and fired in a reduction atmosphere having an oxygen partial pressure of $10^{-4}$ atm. When a base metal (Cu, for example) is used as an electrode material, the electrode material will be oxidized to possibly impair the conductivity thereof in case calcination is performed in an oxidizing atmosphere (in the air, for example) even at low temperature. This is disadvantageous. On the other hand, when the calcination is performed in the reduction atmosphere, since a fired body obtained contains many oxygen voids in comparison with a sintered body fired in the air, the insulation resistance at high temperatures (100°C or more) is particularly lowered to lower the high-temperature load life (insulated life) of a product. This is also disadvantageous. There are many cases where the temperature range of 100°C to 200°C is also the operation standard temperature of products, and the drop of the insulation resistance and insulated life in this temperature range considerably deteriorates the reliability of the products. This is seriously problematic. From these points, in the multilayer piezoelectric element, the calcination is performed in an atmosphere of a relatively high oxygen partial pressure, and partial oxidization of the Cu that is the electrode material is tolerated. This is equivalent to a sacrifice of the electrode characteristics.

The multilayer piezoelectric element has substances for suppressing melting, elevating a melting point, suppressing diffusion and for other such purposes added to a paste material for an electrode in order to prevent diffusion or segregation of Cu. However, there is a possibility of the addition of these substances adversely affecting the characteristics of the piezoelectric ceramic composition constituting the piezoelectric body layer and being disadvantageous from the viewpoint of the cost and the number of man-hour of the production.

As described above, it has been known to the art that the segregation of Cu in granular form in a piezoelectric ceramic composition containing Cu in consequence of using Cu as an electrode material, adversely affects the characteristics of the composition. However, no study has been made on a further detailed structure. Even in a structure in which Cu does not segregate in granular form, the composition possibly falls short of the insulating property in the grain boundaries and of the acceleration voltage load property. In spite of this, no attempt has been made on an improvement thereof.

In the present invention, through control of firing conditions, for example, the piezoelectric ceramic is of a structure having Cu distributed unevenly in the grain boundaries. With this, the insulating property in the grain boundaries is heightened and the acceleration voltage load property is greatly improved. In addition, the maldistribution of Cu in the grain boundaries has no effect on the composition of the crystal grains constituting the main body of the piezoelectric ceramic composition, resulting in no degradation of the original piezoelectric characteristics.

Thus, in the piezoelectric ceramic composition and piezoelectric element according to the present invention, the structural feature that Cu is unevenly distributed in the grain boundaries enables the acceleration voltage load property etc. to be improved and does not require addition of the substance for suppressing diffusion etc. as has been done in the conventional multilayer piezoelectric element. It can be said, therefore, that the present invention differs greatly from the conventional technique raising only the presence or absence of the segregation in granular form as a significant problem.

According to the present invention, it is possible to use an inexpensive metal material, such as Cu or Ni, as a material for internal electrodes, improve the electrical resistance, provide a piezoelectric ceramic composition exhibiting no loss of piezoelectric characteristics, such as electromechanical coupling factor kr, for example. According to the present invention, therefore, it is made possible to provide a piezoelectric element excellent in insulated life and high in reliability in spite of low cost.

The above and other objects, characteristic features and advantages of the present invention will become apparent to those skilled in the art from the description to be made herein below with reference to the accompanying drawings.

BRIEF DESCRIPTION OF THE DRAWINGS

FIG. 1 is a schematic cross section showing one example of the configuration of a multilayer actuator.

FIG. 2 is a schematic view showing the grain boundaries of a piezoelectric ceramic composition.

FIG. 3 is a diagram showing one example of a temperature profile at the time of calcination in the fourth embodiment.

FIG. 4 is a diagram showing the oxygen partial pressure range of an atmospheric gas introduced at the time of calcination together with the oxygen partial pressure under which metal copper and lead oxide can coexist.

FIG. 5 is an EPMA photograph of the cross section of the Cu internal electrode multilayer fabricated in Experiment 16.

FIG. 6 is an EPMA image of the piezoelectric element fabricated in Experiment 19.

FIG. 7 is an FE-TEM image of the piezoelectric element fabricated in Experiment 19.

FIG. 8 is a diagram showing the results of analysis by a TEM-EDS of the compositions at each point in the FE-TEM image shown in FIG. 7.

FIG. 9 is an enlarged FE-TEM image of the piezoelectric element fabricated in Experiment 19.

FIG. 10 is a diagram showing the results of analysis by TEM-EDS of the composition in the vicinity of the grain boundaries.

FIG. 11 is a TEM image showing Cu having segregated in granular form.

DETAILED DESCRIPTION OF THE PREFERRED EMBODIMENTS

A piezoelectric ceramic composition, a production method thereof, a piezoelectric element and a fabrication method thereof according to the present invention will be described in detail hereinafter.

A piezoelectric ceramic composition according to the first embodiment of the present invention has as a chief ingredient a composite oxide that has Pb, Ti and Zr as constituent elements. Here, the composite oxide includes three-element-based composite oxides, such as lead titanate ($PbTiO_3$), lead zirconate ($PbZrO_3$) and lead zinc niobate [$Pb(Zn_{1/3}Nb_{2/3})O_3$] and these three-element-based composite oxides having part of Pb substituted with Sr, Ba, Ca, etc., for example.

As concrete compositions, composite oxides represented by Formulae (1) and (2) shown below can be cited, in which the oxygen compositions are stoichiometrically measured and in which any deviation from the stoichiometric composition can be tolerated in each of the actual compositions.

$$Pb_a[(Zn_{1/3}Nb_{2/3})_x Ti_y Zr_z]O_3 \qquad (1)$$

(wherein $0.96 \leq a \leq 1.03$, $0.05 \leq x \leq 0.15$, $0.25 \leq y \leq 0.5$, $0.35 \leq z \leq 0.6$ and $x+y+z= 1$)

$$(Pb_{a \cdot b} Me_b)[(Zn_{1/3}Nb_{2/3})_x Ti_y Zr_z]O_3 \qquad (2)$$

(wherein $0.96 \leq a \leq 1.03$, $0 < b \leq 0.1$, $0.05 \leq x \leq 0.15$, $0.25 \leq y \leq 0.5$, $0.35 \leq z \leq 0.6$, $x + y + z = 1$ and Me stands for at least one species selected from the group consisting of Sr, Ca and Ba)

These composite oxides have a perovskite structure, in which Pb and substituted element Me in Formula (2) are placed at the so-called A-site, and Zn, Nb, Ti and Zr are placed at the so-called B-site in the perovskite structure.

In the composite oxides represented in Formulae (1) and (2), the proportion "a" of the element placed at the A-site is preferred to be $0.96 \leq a \leq 1.03$. When it is less than 0.96, calcination at low temperatures will possibly be difficult to perform. Conversely, when it exceeds 1.03, the density of the piezoelectric ceramic to be obtained will be lowered, resulting in possible failure to obtain satisfactory piezoelectric characteristics and possible decrease in mechanical strength.

In the composite oxides represented by Formula (2), part of Pb is substituted with the substituted element Me (Sr, Ca, Ba), thereby enabling the piezoelectric strain constant to be made high. When the amount "b" of Me substituted is unduly large, the sintering property is lowered, with the result that the piezoelectric strain constant is made small and the mechanical strength is also lowered. Also, the Curie temperature tends to be lowered with an increase of the substitution amount "b". Therefore, the substitution amount "b" of the substituted Me is preferably 0.1 or less.

On the other hand, of the elements placed at the B-site, the proportion "x" of Zn and Nb is preferred to be $0.05 \leq x \leq 0.15$. The proportion "x" has an effect on the firing temperature and, when the value is less than 0.05, the effect of lowering the firing temperature will possibly become unsatisfactory. Conversely, when it exceeds 0.15, the overage will have an effect on the sintering property, thereby possibly making the piezoelectric strain constant small and at the same time lowering the mechanical strength.

Of the elements placed at the B-site, desirable ranges of the proportion "y" of Ti and the proportion "z" of Zr are set, respectively, from the viewpoint of the piezoelectric characteristics. To be specific, the proportion "y" of Ti is preferred to be $0.25 \leq y \leq 0.5$, and the proportion "z" of Zr $0.35 \leq z \leq 0.6$. By setting "y" and "z" within the respective ranges mentioned above, a large piezoelectric strain constant can be acquired in the vicinity of the Morphotropic Phase Boundary (MPB).

One of the significant features of the first embodiment lies in that the piezoelectric ceramic composition contains the composite oxide as a chief ingredient and, as a first accessory ingredient, at least one species selected from the group consisting of Mn, Co, Cr, Fe and Ni. The presence of the first accessory ingredient can remarkably suppress a drop of the electrical resistance at high temperatures.

When the content of the first accessory ingredient is unduly large, there is a possibility of the piezoelectric property that is the electromechanical coupling factor kr, for example, being lowered. The content, therefore, is preferred to be 0.2 mass% or less excluding 0 mass%. When the content of the first accessory ingredient exceeds 0.2 mass%, there is a possibility of the electromechanical coupling factor kr being 50 or less. More preferable content is in the range of 0.1 to 0.2 mass%. It is to be noted that the content of the first accessory ingredient is a value in terms of an oxide. When the first accessory ingredient is Mn, for example, the value thereof is in terms of MnO. In the case of Co, the value thereof is in terms of CoO and, in the case of Cr, the value thereof is in terms of CrO. Similarly, the value of Fe is in terms of FeO and the value of Ni is in terms of NiO.

The piezoelectric ceramic composition in the first embodiment may contain a second accessory ingredient in addition to the first accessory ingredient. In this case, the second accessory ingredient is at least one species selected from the group consisting of Ta, Sb, Nb and W. The presence of the second accessory ingredient can enhance the piezoelectric characteristics and mechanical strength. The content of the second accessory ingredient, however, is preferred to be 1.0 mass% or less in terms of an oxide. The contents of Ta, Sb, Nb and W are 1.0 mass% or less, respectively, in terms of $Ta_2O_5$, $Sb_2O_3$, $Nb_2O_5$ and $WO_3$. When the content of the second accessory ingredient exceeds 1.0 mass% in terms of the oxide, the sintering property is lowered to possibly lower the piezoelectric characteristics.

The configuration with respect to the composition of the piezoelectric ceramic composition in the first embodiment is as described above. Another significant feature of the first embodiment lies in that the piezoelectric ceramic composition is a product obtained by calcination under reducing and firing conditions. When calcination is performed in an oxidizing atmosphere, as described earlier, a precious metal has to be used as a material, for example, for an internal electrode in a piezoelectric element. On the other hand, since the piezoelectric ceramic composition of the present invention is a product obtained through calcination under the reducing and firing conditions, an inexpensive material, such as Cu, Ni, etc., can be used for an internal electrode. Here, the reducing and firing conditions include a firing temperature in the range of 800°C to 1200°C and an oxygen partial pressure in the range of $1 \times 10^{-10}$ to $1 \times 10^{-6}$ atm.

When calcination is performed under the reducing and firing conditions, as described above, a drop in electrical resistance at high temperatures poses a problem. However, since the piezoelectric ceramic composition of the present embodiment contains the first accessory ingredient, such a problem can be avoided. Furthermore, since the piezoelectric ceramic composition is a product obtained through calcination under the reducing and firing conditions, an inexpensive Cu, Ni, etc. can be used for the internal electrode and, moreover, a drop in piezoelectric characteristics can also be avoided, with the problem of lowering the electrical resistance at high temperature solved as described above.

Next, a method for the production of the piezoelectric ceramic composition in the first embodiment will be described. The piezoelectric ceramic composition is produced by calcination under the reducing and firing conditions. The producing method is as follows.

First, PbO powder, ZnO powder, $Nb_2O_5$ powder, $TiO_2$ powder and $ZrO_2$ powder are prepared as raw materials for a chief ingredient. When the chief ingredient is the composite oxide represented by Formula (2), at least one species selected from the group consisting of $SrCO_3$ powder, $BaCO_3$ powder and $CaCO_3$ powder is further prepared.

In addition, as the raw material for a first accessory ingredient (additive species), at least one species of oxides and carbonates of the elements mentioned above, such as $MnCO_3$, CoO, $Cr_2O_3$, $Fe_2O_3$, NiO, etc. is prepared. When a second accessory ingredient is to be added, one necessary for the addition is selected from $Ta_2O_5$ powder, $Sb_2O_3$ powder, $Nb_2O_5$ powder and $WO_3$ powder.

The raw materials for the chief ingredient, first accessory ingredient and second accessory ingredient are not limited to the oxide powder and carbonate powder enumerated above. Any element enabled to be an oxide when being fired can be used. Carbonate powder, oxalate powder and hydroxide powder, for example, can be used in place of the oxide powder listed above. Similarly, oxide powder, oxalate powder and hydroxide powder can be used instead of the carbonate powder listed above.

The raw materials are thoroughly dried, weighed out in accordance with an intended final composition and thoroughly mixed in an organic solvent or water with a ball mill, for example. The mixture is dried and then calcined at a temperature of around 700°C to 950°C for one to four hours. The calcined body is thoroughly pulverized in an organic solvent or water with a ball mill, for example, dried, added with a binder, such as polyvinyl alcohol, acrylic resin, etc., pelletized and press molded using a uniaxial press molding machine, Cold Isostatic Press (CIP) or other such machine.

After the molding, the molded body is fired under reducing and firing conditions, specifically, in a reduction atmosphere (under an oxygen partial pressure of $1 \times 10^{-10}$ to $1 \times 10^{-6}$ atm., for example) at a firing temperature of 800°C to 1200°C. In the present invention, since calcination is performed under reducing and firing conditions and further at relatively low temperatures to produce a piezoelectric ceramic composition, constraints to the electrode material used for an internal electrode, for example, can be removed to enable inexpensive electrode material, such as Cu, Ni, to be used. The problem of deterioration in electrical resistance etc. by the calcination under the reducing and firing conditions is solved by the addition of the first accessory ingredient and no problem on the piezoelectric characteristics is posed.

The sintered body obtained after the calcination is polished, if necessary, and subjected to a poling process, in which an electrode for polarization is connected to the sintered body, which is then placed in a heated silicone oil, to which an electric field is applied, thereby obtaining a piezoelectric ceramic composition (piezoelectric ceramic).

Incidentally, in the producing method, the raw materials for the first and second accessory ingredients may be mixed with the raw materials for the chief ingredient prior to the calcination, i.e. in the initial raw material mixing process, for example, or with the calcined body pulverized.

The piezoelectric ceramic composition can be used as a piezoelectric material for piezoelectric elements including actuators, piezoelectric transformers, ultrasonic motors, piezoelectric buzzers, sounding bodies, sensors, etc. Therefore, an example of the configuration of a piezoelectric element will next be described with reference to a multilayer actuator by way of example.

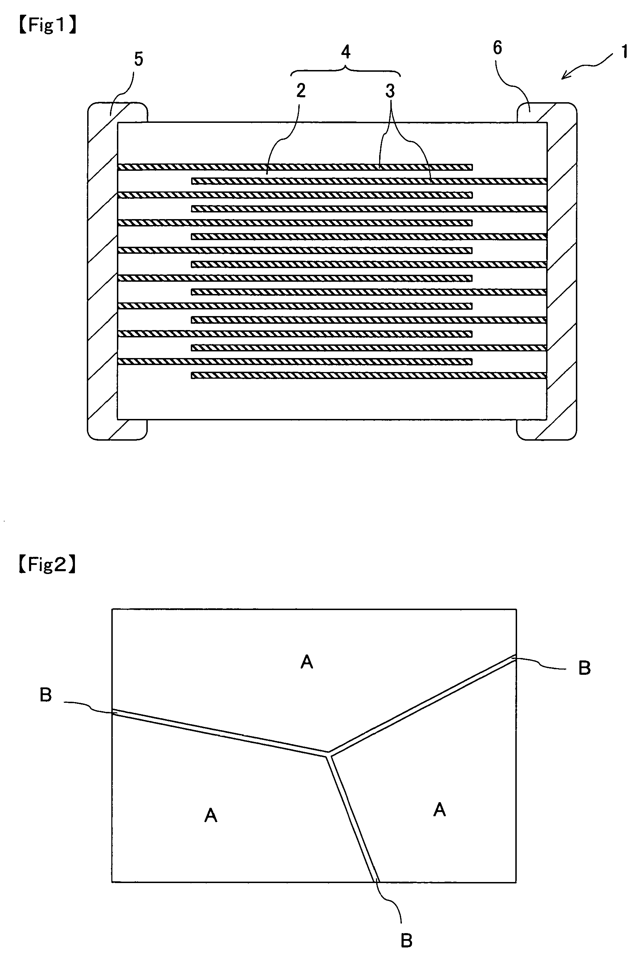

FIG. 1 illustrates one example of a multilayer actuator. As shown in FIG. 1, the multilayer actuator 1 is provided with a multilayer body 4 having internal electrodes 3 each inserted between adjacent piezoelectric layers 2 and contributing to displacement as an active portion. The thickness of one piezoelectric layer 2 can arbitrarily be set and is generally set to be in the range of around 1 μm to 100 μm, for example. The multilayer body 4 has on opposite sides a piezoelectric layer region having no internal electrode 3 and serving as an inactive region. The thickness of the piezoelectric layers at these portions may be set to be larger than that of the piezoelectric layer between the adjacent electrodes 3.

In the piezoelectric element of this embodiment, the piezoelectric ceramic composition described earlier is used for the piezoelectric layers 2. The internal electrodes 3 function as electrodes for applying voltage to each piezoelectric layer 2 and, not to mention, are formed of a conductive material. In this case, though precious metals, such as Ag, Au, Pt, Pd, etc. can be used as the conductive material, since the piezoelectric ceramic composition of the present invention is used for the piezoelectric layers 2, inexpensive electrode material, such as Cu, Ni, etc. can be used as the conductive material. As described earlier, since the piezoelectric ceramic composition of the present invention is obtained through calcination under reducing and firing conditions, even Cu, Ni, etc. easy to oxidize and low in melting point can be used as the internal electrode 3. Use of inexpensive electrode materials can bring about curtailment in production cost of multilayer actuators 1.

The internal electrodes 3 are extended alternately in the opposite directions, for example, and the opposite ends of the multilayer body 4 in the extended directions are provided with terminal electrodes 5 and 6, respectively. The terminal electrodes 5 and 6 may be formed by sputtering a metal, such as Au etc., or through seizure of paste for electrodes. The thickness of the terminal electrodes 5 and 6 is appropriately determined depending on the intended purposes, sizes of the multilayer actuators 1, etc. It is generally in the range of around 10 μm to 50 μm.

The multilayer actuator 1 is fabricated in the following manner. First, a vehicle is added to and kneaded with the powder of the calcined body pulverized as described earlier (including the first accessory ingredient) to produce paste for a piezoelectric layer and, at the same time, a conductive material is kneaded with a vehicle to produce paste for an internal electrode. Incidentally, the paste for an internal electrode may be added when necessary with an additive, such as a dispersant, plasticizer, dielectric material, insulating material, etc.

Subsequently, a green chip that is a precursor of the multilayer body 4 is produced by a printing method, sheet method, etc. using paste for the piezoelectric layer and paste for the internal electrode. Furthermore, the green chip is subjected to a debinder treatment and fired under the reducing and firing conditions to obtain the multilayer body 4. The multilayer body thus obtained is subjected to barrel polishing or sandblasting to polish the end face thereof. By sputtering a metal or by subjecting paste for a terminal electrode produced in the same manner as the paste for the internal electrode to seizure through printing or transferring to form terminal electrodes 5 and 6.

In the piezoelectric element having the configuration described above, since the internal electrode can be formed of an inexpensive electrode material, such as Cu, Ni, etc., the production cost can be reduced to a great extent. In addition, since the piezoelectric layer 2 formed from the piezoelectric ceramic composition fired under the reducing and firing conditions exhibits small reduction in electrical resistance at high temperatures and also small reduction in electromechanical coupling factor kr, a piezoelectric element excellent in performance and reliability can be materialized.

The second embodiment of the present invention will now be described. A piezoelectric ceramic composition according to this embodiment has as a chief ingredient a composite oxide that has Pb, Ti and Zr as constituent elements and as a first accessory ingredient $CuO_x$ ($x \geq 0$). The composite oxide (chief ingredient) having Pb, Ti and Zr as constituent elements is the same as in the first embodiment and, therefore, the explanation thereof will be omitted here. As $CuO_x$ ($x \geq 0$), Cu oxides in the arbitrarily oxidized state, such as Cu2O, CuO, etc. and Cu (in the case of x = 0) can be cited. Two or more of them may be contained.

Since the piezoelectric ceramic composition contains $CuO_x$ ($x \geq 0$) as the first accessory ingredient, reduction in electrical resistance at high temperatures can be suppressed, and the insulated life (hot load life) can be improved to a great extent. When the content of $CuO_x$ ($x \geq 0$) is unduly large, however, the electromechanical coupling factor kr will possibly be lowered. Therefore, it is preferred to be 3.0 mass% or less excluding 0 mass%. When the content of $CuO_x$ ($x \geq 0$) exceeds 3.0 mass%, the electromechanical coupling factor kr will possibly be lowered to 50 or less. More preferable content is in the range of 0.01 to 3.0 mass%.

The piezoelectric ceramic composition of this embodiment may contain a second accessory ingredient in addition to the first accessory ingredient. In this case, the second accessory ingredient is at least one species selected from the group consisting of Ta, Sb, Nb and W. The addition of the second accessory ingredient enables the piezoelectric characteristics and mechanical strength to be enhanced. The content of the second accessory ingredient is preferred to be 1.0 mass% or less in terms of an oxide. The contents of Ta, Sb, Nb and W are 1.0 mass% or less, respectively, in terms of $Ta_2O_5$, $Sb_2O_3$, $Nb_2O_5$ and $WO_3$. When the content of the second accessory ingredient exceeds 1.0 mass% in terms of the oxide, the sintering property is lowered to possibly lower the piezoelectric characteristics.

The composition of the piezoelectric ceramic composition according to the second embodiment has been described. The piezoelectric ceramic composition of this embodiment is produced by calcination under the reducing and firing conditions. As described earlier, the calcination in the oxidizing atmosphere requires use of a precious metal as an electrode material for the internal electrode of a piezoelectric element, for example. On the other hand, since the piezoelectric ceramic composition in this embodiment is produced by calcination under reducing and firing conditions, an inexpensive electrode material, such as Cu, Ni, etc. can be used for the internal electrode. The reducing and firing conditions include the firing temperature in the range of 800°C to 1200°C and the oxygen partial pressure in the range of $1 \times 10^{-10}$ to $1 \times 10^{-6}$ atm., for example.

Though the calcination under the reducing and firing conditions poses problems of lowering the electrical resistance at high temperatures and insulated life (hot load life), the problems can be avoided because $CuO_x$ ($x \geq 0$) is contained as the first accessory ingredient. That is to say, since the piezoelectric ceramic composition is produced by calcination under the reducing and firing conditions, an inexpensive electrode material, such as Cu, Ni, etc. can be used for the internal electrode and, moreover, a decrease in electrical resistance at high temperatures and a decrease in insulated life (hot load life) can be eliminated.

A method for the production of the piezoelectric ceramic composition of this embodiment will be described. The piezoelectric ceramic composition of this embodiment is produced through calcination under reducing and firing conditions. The production method is as follows.

PbO powder, ZnO powder, $Nb_2O_5$ powder, $TiO_2$ powder and $ZrO_2$ powder are prepared as the raw materials for the chief ingredient. When the chief ingredient is the composite oxide represented by Formula (2), at least one of $SrCO_3$ powder, $BaCO_3$ powder and $CaCO_3$ powder is further prepared.

At least one of Cu, Cu2O and CuO is prepared as the first accessory ingredient (additive species). In the case of adding the second accessory ingredient, a necessary one selected from $Ta_2O_5$ powder, $Sb_2O_3$ powder, $Nb_2O_5$ powder and $WO_3$ powder is prepared.

The raw materials for the chief ingredient and second accessory ingredient are not limited to the oxide powder and carbonate powder enumerated above. Any element enabled to be an oxide when being fired can be used. Carbonate powder, oxalate powder and hydroxide powder, for example, can be used in place of the oxide powder listed above. Similarly, oxide powder, oxalate powder and hydroxide powder can be used instead of the carbonate powder listed above.

The raw materials are thoroughly dried, weighed out in accordance with an intended final composition and thoroughly mixed in an organic solvent or water with a ball mill, for example. The mixture is dried and then calcined at a temperature of around 700°C to 950°C for one to four hours. The calcined body is thoroughly pulverized in an organic solvent or water with a ball mill, for example, dried, added with a binder, such as polyvinyl alcohol, acrylic resin, etc., pelletized and press molded using a uniaxial press molding machine, Cold Isostatic Press (CIP) or other such machine.

After the molding, the molded body is fired under reducing and firing conditions, specifically, in a reduction atmosphere (under an oxygen partial pressure of $1 \times 10^{-10}$ to $1 \times 10^{-6}$ atm., for example) at a firing temperature of 800°C to 1200°C. In the present invention, since calcination is performed under reducing and firing conditions and further at relatively low temperatures to produce a piezoelectric ceramic composition, constraints to the electrode material used for an internal electrode, for example, can be removed to enable inexpensive electrode material, such as Cu, Ni, to be used. The problem of deterioration in electrical resistance etc. by the calcination under the reducing and firing conditions is solved by the addition of the first accessory ingredient and no problem on the piezoelectric characteristics is posed.

The sintered body obtained after the calcination is polished, if necessary, and subjected to a poling process, in which an electrode for polarization is connected to the sintered body, which is then placed in a heated silicone oil, to which an electric field is applied, thereby obtaining a piezoelectric ceramic composition (piezoelectric ceramic).

Incidentally, in the producing method, the raw materials (additive species) for the first accessory ingredient may be mixed with the raw materials for the chief ingredient prior to the calcination, i.e. in the initial raw material mixing process, for example, or with the calcined body pulverized.

The piezoelectric ceramic composition can be used as a piezoelectric material for piezoelectric elements including actuators, piezoelectric transformers, ultrasonic motors, piezoelectric buzzers, sounding bodies, sensors, etc. The configuration of a multilayer actuator is the same as described in the first embodiment (multilayer actuator shown in FIG. 1).

In the piezoelectric element of this embodiment, the piezoelectric ceramic composition described earlier is used for the piezoelectric layers 2. The internal electrodes 3 function as electrodes for applying voltage to each piezoelectric layer 2 and, not to mention, are formed of a conductive material. In this case, though precious metals, such as Ag, Au, Pt, Pd, etc. can be used as the conductive material, since the piezoelectric ceramic composition of the present embodiment is used for the piezoelectric layers 2, inexpensive electrode material, such as Cu, Ni, etc. can be used as the conductive material. As described earlier, since the piezoelectric ceramic composition of the present embodiment is obtained through calcination under reducing and firing conditions, even Cu, Ni, etc. easy to oxidize and low in melting point can be used as the internal electrode 3. Use of inexpensive electrode materials can bring about curtailment in production cost of multilayer actuators 1.

In the piezoelectric element having the configuration described above, since the internal electrode can be formed of an inexpensive electrode material, such as Cu, Ni, etc., the production cost can be reduced to a great extent. In addition, since the piezoelectric layer 2 formed from the piezoelectric ceramic composition fired under the reducing and firing conditions exhibits small reduction in insulation resistance and hot load property and also small reduction in electromechanical coupling factor kr, a piezoelectric element excellent in performance and reliability can be materialized.

The third embodiment of the present invention relating to a multilayer piezoelectric element will be described. In the multilayer piezoelectric element, the piezoelectric body layer contains at least one of ingredients represented by $CuO_x$ ($x \geq 0$). As $CuO_x$ ($x \geq 0$), Cu oxides in the arbitrarily oxidized state, such as Cu2O, CuO, etc. and Cu (in the case of $x = 0$) can be cited. Two or more of them may be contained.

The configuration of the multilayer piezoelectric element is the same as that of the multilayer actuator described in the first embodiment (FIG. 1). The piezoelectric ceramic composition used for the piezoelectric body layer has as a chief ingredient a composite oxide that has Pb, Ti and Zr as constituent elements. The composite oxide as the chief ingredient is the same as that described in the first embodiment.

Since the piezoelectric body layer of the multilayer piezoelectric element contains $CuO_x$ ($x \geq 0$), reduction in electrical resistance at high temperatures can be suppressed, and the insulation characteristics can be improved to a great extent. When the content of $CuO_x$ ($x \geq 0$) is unduly large, however, the electromechanical coupling factor kr will possibly be lowered. Therefore, it is preferred to be 3.0 mass% or less excluding 0 mass%. When the content of $CuO_x$ ($x \geq 0$) exceeds 3.0 mass%, the electromechanical coupling factor kr will possibly be lowered to 50 or less. More preferable content is in the range of 0.01 to 3.0 mass%.

To cause $CuO_x$ ($x \geq 0$) to exist in the piezoelectric body layer, Cu contained in the internal electrode layer may be diffused into the piezoelectric body layer, or separate Cu may be added to the raw material composition for the piezoelectric body layer. What is important is that the piezoelectric body layer contains Cu. The adding method or existing mode thereof has no object.

The multilayer piezoelectric element of this embodiment is produced by calcination under the reducing and firing conditions in the same manner as in the first or second embodiment. The calcination in the oxidizing atmosphere to fabricate a multilayer piezoelectric element requires use of a precious metal as an electrode material for the internal electrode, for example. On the other hand, since the multilayer piezoelectric element in this embodiment is produced by calcination under reducing and firing conditions, an inexpensive electrode material of Cu can be used for the internal electrode. The reducing and firing conditions include the firing temperature in the range of 800°C to 1200°C and the oxygen partial pressure in the range of $1 \times 10^{-10}$ to $1 \times 10^{-6}$ atm., for example.

Though the calcination under the reducing and firing conditions poses a problem of lowering the electrical resistance at high temperatures, the problem can be avoided because the piezoelectric body layer contains $CuO_x$ ($x \geq 0$). That is to say, since the multilayer piezoelectric element of this embodiment is produced by calcination under the reducing and firing conditions, Cu can be used for the internal electrode layer and, moreover, a decrease in electrical resistance at high temperatures can be eliminated.

A method for the fabrication of the multilayer piezoelectric element having the configuration described above will be described. First, a vehicle is added to and kneaded with the powder of the piezoelectric ceramic composition having the calcined body pulverized to produce paste for a piezoelectric layer and, at the same time, Cu powder that is a conductive material is kneaded with a vehicle to produce paste for an internal electrode. Incidentally, the paste for an internal electrode may be added when necessary with an additive, such as a dispersant, plasticizer, dielectric material, insulating material, etc.

Subsequently, a green chip that is a precursor of the multilayer body is produced by a printing method, sheet method, etc. using paste for the piezoelectric layer and paste for the internal electrode. Furthermore, the green chip is subjected to a debinder treatment and fired under the reducing and firing conditions to obtain the multilayer body. The calcination is performed in the reduction atmosphere (of an oxygen partial pressure in the range of $1 \times 10^{-10}$ to $1 \times 10^{-6}$ atm., for example) at the firing temperature in the range of 800°C to 1200°C. The multilayer body thus obtained is subjected to barrel polishing or sandblasting to polish the end face thereof. By sputtering a metal or by subjecting paste for a terminal electrode produced in the same manner as the paste for the internal electrode to seizure through printing or transferring to form terminal electrodes.

During the course of performing the calcination under the reducing and firing conditions to produce the multilayer body in the production process, Cu contained in the paste for the internal electrode is diffused into the piezoelectric body layer formed by calcination of the paste for the piezoelectric layer. Thus, the piezoelectric body layer is in the state containing $CuO_x$ ($x \geq 0$) to fabricate the multilayer piezoelectric element of the present invention.

Incidentally, the grain size of Cu contained in the paste for the internal electrode has an effect on the amount of Cu diffused. The amount of Cu diffused is larger when the grain size of Cu is larger, whereas when the grain size is smaller, the amount of Cu diffused is smaller. Since the electrical resistance at high temperatures can be improved when Cu exists in the piezoelectric body layer even in a small amount, it is desirable that the amount of Cu diffused be made smaller in order to deteriorate other characteristics. This means that the grain size of Cu contained in the paste for the internal electrode is desirably as small as possible.

When causing Cu to be contained in the raw material composition of the paste for the piezoelectric layer, the method for the production of a multilayer piezoelectric element is as follows. First, PbO powder, ZnO powder, $Nb_2O_5$ powder, $TiO_2$ powder and $ZrO_2$ powder are prepared as raw materials for a chief ingredient. When the chief ingredient is the composite oxide represented by Formula (2), at least one species selected from the group consisting of $SrCO_3$ powder, $BaCO_3$ powder and $CaCO_3$ powder is further prepared.

In addition, as the additive species of Cu, at least one species of Cu, $Cu_2O$ and CuO is prepared. When an accessory ingredient is to be added to the chief ingredient, one necessary for the addition is selected from $Ta_2O_5$ powder, $Sb_2O_3$ powder, $Nb_2O_5$ powder and $WO_3$ powder.

The raw materials for the chief ingredient and accessory ingredient are not limited to the oxide powder and carbonate powder enumerated above. Any element enabled to be an oxide when being fired can be used. Carbonate powder, oxalate powder and hydroxide powder, for example, can be used in place of the oxide powder listed above. Similarly, oxide powder, oxalate powder and hydroxide powder can be used instead of the carbonate powder listed above.

The raw materials are then thoroughly dried, weighed out in accordance with an intended final composition and thoroughly mixed in an organic solvent or water with a ball mill, for example. The mixture is dried and then calcined at a temperature of around 700°C to 950°C for one to four hours. The calcined body is thoroughly pulverized in an organic solvent or water with a ball mill, for example, dried, added with a binder, such as polyvinyl alcohol, acrylic resin, etc., to prepare paste for the piezoelectric layer.

The subsequent treatments are the same as in the case of diffusion. That is, a green chip that is a precursor of the multilayer body is produced by a printing method, sheet method, etc. using the prepared paste for the piezoelectric layer and paste for the internal electrode. Furthermore, the green chip is subjected to a debinder treatment and fired under the reducing and firing conditions to obtain the multilayer body. The calcination is performed in the reduction atmosphere (of an oxygen partial pressure in the range of $1 \times 10^{-10}$ to $1 \times 10^{-6}$ atm., for example) at the firing temperature in the range of 800°C to 1200°C. The multilayer body thus obtained is subjected to barrel polishing or sandblasting to polish the end face thereof. By sputtering a metal or by subjecting paste for a terminal electrode produced in the same manner as the paste for the internal electrode to seizure through printing or transferring to form terminal electrodes.

In the production method described above, since calcination is performed under reducing and firing conditions and further at relatively low temperatures, constraints to the electrode material used for an internal electrode, for example, can be removed to enable Cu to be used. The problem of deterioration in electrical resistance by the calcination under the reducing and firing conditions is solved by the addition of $CuO_x$ ($x \geq 0$) and no problem on the piezoelectric characteristics is posed.

The fourth embodiment of the present invention is directed to a piezoelectric ceramic composition which has as a chief ingredient a composite oxide having Pb, Ti and Zr as constituent elements similarly to the first or second embodiment and which has a structure having Cu unevenly distributed in the grain boundaries thereof. The piezoelectric ceramic composition having the composite oxide as the chief ingredient is comprised of an aggregate of crystal grains "A" as schematically shown in FIG. 2. In the boundaries of the crystal grains "A," i.e. grain boundaries, so-called grain boundary layers "B" exist as a very thin layer. In the piezoelectric ceramic composition of this embodiment, Cu is unevenly distributed in the grain boundary layers "B."

This maldistribution of Cu in the grain boundary layers "B" cannot be analyzed with the Electron Probe Micro-Analysis (EPMA), but with a Field Emission Transmission Electron Microscope (FE-TEM). When the piezoelectric ceramic composition of the present invention is analyzed with the FE-TEM, the Cu peaks are observed in the grain boundaries or a triple point. Though it is ideal for Cu to be unevenly distributed only in the grain boundaries, there is no problem if Cu is partially introduced into the portions of contact of the crystal grains "A" with the grain boundary layers "B." The introduction of Cu toward the inside of the crystal grain is not preferred, but the region in which Cu can exist is limited preferably to within 10 $\mu$m from the grain boundaries. Cu, besides the presence thereof in the grain boundary layers "B," may segregate in granular form, for example. However, the granular segregation of Cu is preferred to be as small as possible. No granular segregation of Cu is more preferable.

While how to cause Cu to be unevenly distributed in the grain boundaries is arbitrary, a piezoelectric ceramic composition may be fired under appropriate firing conditions in a state in contact with Cu. With this, Cu is diffused in the piezoelectric ceramic composition to obtain the aforementioned structure. By using Cu for the internal electrode layer in a piezoelectric element and performing calcination under appropriate firing conditions, the aforementioned structure can be materialized in each piezoelectric body layer. A piezoelectric element will be described hereinafter.

The configuration of a piezoelectric element is the same as that of the multi layer actuator (FIG. 1) described in the first embodiment. The piezoelectric ceramic composition used for the piezoelectric body layer has as a chief ingredient a composite oxide having Pb, Ti and Zr as constituent elements, and the composite oxide as the chief ingredient is the same as the composite oxide described in the first embodiment. In the piezoelectric element, the internal electrodes 3 function as electrodes for applying voltage to each piezoelectric body layer 2 and, not to mention, are formed of a conductive material. In this case, though precious metals, such as Ag, Au, Pt, Pd, etc. can be used as the conductive material, an electrode material containing Cu is used in this embodiment with the aim of maldistribution of Cu in the grain boundaries. To be specific, Cu paste is applied to the internal electrodes 3. Use of Cu as the electrode material can reduce the production cost of the multi layer piezoelectric elements 1.

The piezoelectric element 1 of this embodiment is characterized as described above in that it has a structure in which Cu is unevenly distributed in the grain boundaries of the crystal grains having the composite oxide as the chief ingredient. Since the piezoelectric body layer 2 has a structure having Cu distributed unevenly in the grain boundaries of the crystal grains, the insulation property of the grain boundaries can be heightened to enhance the acceleration voltage load property, for example. Furthermore, since the maldistribution of Cu does not vary the composition of the crystal grains of the composite oxide as the chief ingredient of the piezoelectric body layer 2, the piezoelectric strain property is maintained.

In order for the piezoelectric body layer of the piezoelectric element to have a structure having Cu distributed unevenly in the grain boundaries, it is necessary to appropriately control the firing conditions in obtaining the piezoelectric element. First of all, the piezoelectric element of the present embodiment is preferably obtained through the calcination under the reducing and firing conditions. When calcination is performed in an oxidizing atmosphere when fabricating a piezoelectric element, a precious metal has to be used as a material, for example, for an internal electrode 3. On the other hand, when the calcination is performed under the reducing and firing conditions, inexpensive Cu can be used for the internal electrode 3. Here, the reducing and firing conditions include a firing temperature in the range of 800°C to 1200°C and an oxygen partial pressure in the range of $1 \times 10^{-10}$ to $1 \times 10^{-6}$ atm.

When calcination is performed under the reducing and firing conditions, as described above, a drop in electrical resistance at high temperatures poses a problem. In the piezoelectric element of the present embodiment, however, since the piezoelectric body layer 2 has a structure having Cu distributed unevenly in the grain boundaries, such a problem can be avoided. That is to say, since the multilayer piezoelectric element of the present embodiment is a product obtained through calcination under the reducing and firing conditions, Cu can be used for the internal electrode 3 and, moreover, a drop in electrical resistance at high temperatures can be eliminated.

An example of the advantageous production method of the piezoelectric element 1 of the present embodiment will be described herein below. By performing the calcination under the conditions described hereinafter enables the production of a structure having Cu to be distributed unevenly in the grain boundaries.

In fabricating a piezoelectric element 1, a layering process is first performed, in which raw materials for a piezoelectric body layer 2 are prepared, weighed out in accordance with a target composition and added with a binder, etc. to form a ceramic raw material mixture. As the raw materials for the piezoelectric body layer 2, oxides, carbonates, oxalates and hydroxides of the elements constituting the piezoelectric body layer 2 can be used.. When the piezoelectric body layer 2 is formed of lead zirconium titanate, lead oxide (PbO), titanium oxide ($TiO_2$) and zirconium oxide ($ZrO_2$) are used as the raw material. The ceramic raw material mixture is then shaped into a sheet to form a ceramic precursor layer.

Similarly, metal copper, for example, that is the raw material for the internal electrode layer 3 is prepared and added with a binder, etc. to form a internal electrode raw material mixture. As the raw material for the internal electrode layer 3, the metal oxide is used singly or in combination with other materials. In this case, as the other materials, copper oxides or organic oxide compounds enabled by being fired to form metal oxides, metals other than metal copper, metal oxides, organic metal compounds, etc. can be cited. The internal electrode raw material mixture may be added, if necessary, with additives, such as dispersants, plasticizers, dielectric materials, insulating materials, etc.

The internal electrode raw material mixture is subjected to screen printing etc. onto the ceramic precursor layer to form an internal electrode precursor layer. A plurality of the ceramic precursor layers each having the internal electrode precursor layer thereon are stacked to obtain a multilayer having the ceramic precursor layers and internal electrode precursors stacked alternately.

In a defatting process after the layer process, the multilayer obtained is subjected to defatting treatment. The defatting process is a process of decomposing and removing, by heating, the binders, etc. contained in the ceramic precursor layers and internal electrode precursor layers constituting the multilayer.

The defatting process is generally performed in an atmosphere containing oxygen (in the air, for example). The defatting process in the production method of the present invention can also be performed in an atmosphere containing oxygen. However, it is preferred that the defatting process is performed in a reducing atmosphere for the purpose of suppressing oxidization of the metal copper. Another preferable mode comprises introducing an atmospheric gas containing an inert gas, such as argon (Ar), and water vapor and, when necessary, hydrogen and performing the defatting process in an atmosphere of oxygen partial pressure represented by Formula (3) below:

$$p(O_2) \leq (25331 \times Kp)^{2/3} \qquad (3)$$

wherein Kp stands for the dissociation equilibrium constant of water, and the unit of the oxygen partial pressure $p(O_2)$ is Pa.

When performing the defatting process in the atmosphere of the oxygen partial pressure represented by Formula (3) above while introducing an atmospheric gas containing the inert gas and water vapor, the oxygen partial pressure is preferably in the range shown in Formula (4) below:

$$Kp^2 \times 10^6 \leq p(O_2) \leq (25331 \times Kp)^{2/3} \qquad (4)$$

wherein Kp stands for the dissociation equilibrium constant of water, and the unit of the oxygen partial pressure $p(O_2)$ is Pa.

When the oxygen partial pressure falls short of the above range, lead contained in the ceramic precursor layer is reduced to readily induce metal lead. As a result, problems will possibly arise that the characteristics of the ceramic material are deteriorated and that the induced metal lead is allowed to react with the metal copper contained in the internal electrode precursor layer to be eluted. The elution of the lead in consequence with the reaction with the metal copper will possibly be a cause of breaking etc. in the internal electrode layer 3 formed by firing the internal electrode precursor layer.

When performing the defatting treatment using the atmospheric gas containing the inert gas and water vapor, as described above, the water vapor reacts with hydrocarbon or carbon that are carbon residue components to act as a function to facilitate the removal of the carbon residue by decomposition. Therefore, the amount of water vapor to be introduced is preferably set so that the oxygen partial pressure may fall within the range mentioned above. Specifically, the preferable amount thereof is 7 mol% or more. When the amount falls short of the lower limit, the removal of the binder by decomposition is not fully satisfactory to increase the amount of the carbon residue. Particularly, when the number of ceramic precursor layers stacked becomes large and when the size of each ceramic precursor layer becomes large, the amount of the carbon residue inside thereof is possibly increased. When the amount of the water vapor to be introduced is unduly large, the oxygen partial pressure will also become too high, with the result that the metal copper contained in the internal electrode precursor layer is liable to be changed into cuprous oxide ($Cu_2O$). Therefore, the amount of the water vapor to be introduced is preferred to be 50 mol% or less. The cuprous oxide is diffused in the ceramic layer (piezoelectric body layer 2) at 680°C, for example, to deteriorate the characteristics.

The water vapor also acts as a function to generate oxygen due to its dissociation equilibrium and suppress variation of the oxygen partial pressure. Utilization of the dissociation equilibrium of the water vapor enables the oxygen partial pressure at the time of the defatting treatment to be adjusted to an extremely low oxygen partial pressure. When the oxygen partial pressure in the defatting treatment is high, the metal copper is oxidized and swollen to possibly induce cracks and other such defects. Since utilization of the water vapor can control the oxygen partial pressure to a low value, it is made possible to suppress cracks otherwise induced by the oxidization of the metal oxide. Incidentally, though introduction of oxygen into the atmospheric gas is conceivable, by this it makes it extremely difficult to control the oxygen partial pressure to a low value so as not to induce cracks. Also in this aspect, control of the oxygen partial pressure by water vapor proves advantageous.

When performing the defatting process in the atmosphere of the oxide partial pressure expressed in Formula (3) while introducing an atmospheric gas containing inert gas and water vapor, hydrogen can be introduced together with water vapor into the atmospheric gas. This is because hydrogen also has a function to remove carbon residue. However, introduction of hydrogen in a large amount lowers the oxygen partial pressure, resulting in possible cases of an increase of carbon residue and ready reduction of the lead contained in the ceramic precursor layer. Hydrogen having a concentration 10 mol ppm or less in the atmospheric gas proves preferable.

In the defatting process, preferably the defatting treatment temperature is set to be 600°C or less. This is because when the temperature exceeds 600°C, lead-based ceramic materials begin to be sintered and are consequently densified to stop up air vents, resulting in a possibility of volatilization of the decomposed binder being prevented.

After the defatting process, the multilayer is fired in the firing process. In producing the piezoelectric element 1 of the present embodiment, it is important to control an atmosphere during the course of calcination. The control of the atmosphere in the cancining process will be described below.

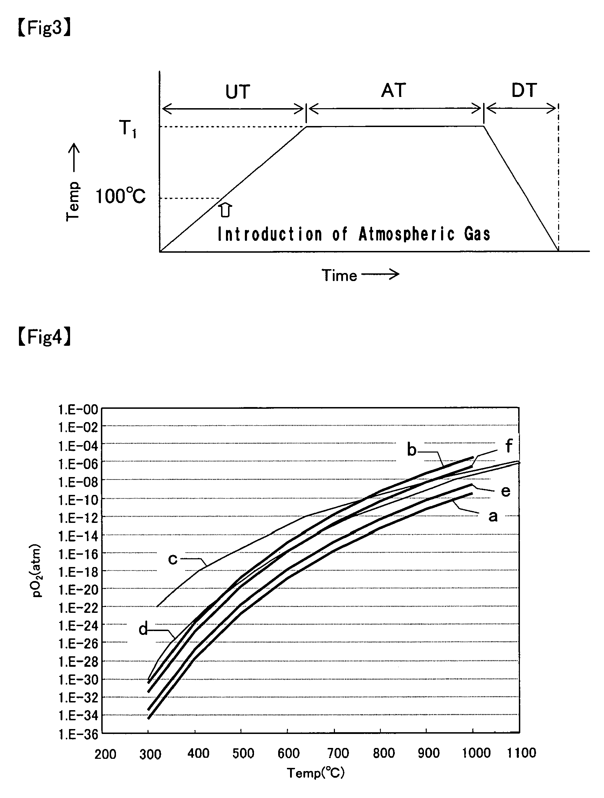

FIG. 3 shows one example of the temperature profile at the time of calcination. The multilayer is fired through the course of a temperature up period UT in which the temperature is gradually elevated, a temperature assurance period AT in which the temperature is held constant to stabilize the calcination and a temperature down period DT in which the temperature is lowered to cool the fired multilayer. Here, during the temperature assurance period AT, a so-called calcination-reaching temperature $T_1$ is maintained to perform substantial calcination. In the case of the aforementioned lead zirconium titanate-based ceramic material, the calcination-reaching temperature $T_1$ is set to be in the range of 900°C to 1000°C.

In the calcination, an atmospheric gas is introduced into a furnace to set the in-furnace atmosphere to be a prescribed atmosphere. In the present invention, however, a prescribed atmospheric gas is introduced into the furnace at the time the in-furnace temperature has exceeds 100°C. The gases to be introduced are inert gas (nitrogen, Ar, etc.), hydrogen and an atmospheric gas containing water vapor. These component gases are adjusted so that the oxygen partial pressure falls within the range expressed in Formula (5) below:

$$10^5 \times Kp^2 \leq p(O_2) \leq 10^9 \times Kp^2 \qquad (5)$$

Where the atmospheric gas containing inert gas, hydrogen and water vapor and adjusted so that the oxygen partial pressure falls within the prescribed range is introduced into the furnace, as described above, when the in-furnace temperature is less than 100°C, the water vapor will possibly be condensed. This condensation of air vapor greatly obstructs the adjustment of the oxygen partial pressure of the atmospheric gas. This is why the atmospheric gas is introduced into the furnace at the time the in-furnace temperature exceeds 100°C. The in-furnace atmosphere before the introduction of the atmospheric gas is arbitrary. It may be an inert gas atmosphere or an air atmosphere.

When the atmospheric gas containing the inert gas, hydrogen and water vapor is introduced into the furnace after the in-furnace temperature exceeds 100°C, dissociation of the water vapor proceeds, with the temperature ascent, to gradually elevate the oxygen partial pressure. FIG. 4 shows the elevation of the oxygen partial pressure accompanied with the temperature ascent, in which curve "a" shows a variation in oxygen partial pressure when $p(O_2) = 10^5 \times Kp^2$ and curve "b" a variation when $p(O_2) = 10^9 \times Kp^2$.

In FIG. 4, curve "c" shows oxygen dissociation pressure of copper and curve "d" oxygen dissociation pressure of lead (Pb). In the case of copper, when the oxygen partial pressure fails to reach curve "c," the copper is maintained in the state of metal copper, whereas when the oxide partial pressure exceeds line "c," the copper is oxidized into cuprous oxide ($Cu_2O$). In the case of lead (Pb), when the oxygen partial pressure falls short of line "d," the lead is metallized, whereas when the oxygen partial pressure exceeds line "d," the lead is maintained in the state of lead oxide (PbO).

Comparing lines "c" and "d" showing the oxygen dissociation pressures of copper and lead with the oxygen partial pressures (lines "a" and "b") of the atmospheric gas introduced in the present invention, not all portions of lines "a" and "b" in all the temperature region fall within a region intervening between lines "c" and "d." At the calcination-reaching temperature $T_1$ (900°C to 1000°C) set in the assurance temperature period AT, however, all the portions of lines "a" and "b" lie in the vicinity of the aforementioned oxygen dissociation pressure (i.e., in the vicinity of lines "d" and "c") and, at the range of temperatures lower than the temperature Ti, all the portions of lines "a" and "b" lie below line "c."

As a result of the series of studies made by the present inventors, it has been found that it is not always necessary to control the atmosphere at the calcination to fall within the oxygen partial pressure (area sandwiched between lines "c" and "d") under which metal copper and lead oxide can coexist at any temperature and that the object can be attained if the oxide partial pressure of the atmospheric gas at the calcinations-reaching temperature T1 is set in the vicinity of the oxide partial pressure under which metal copper and lead oxide can coexist.

Where the oxygen partial pressure line of the atmospheric gas falls within the aforementioned range, i.e. between lines "a" and "b", even when a base metal, such as copper, is used for the internal electrode layer, it is made possible to produce a multilayer piezoelectric element excellent in quality without inducing oxidation or elution of the internal electrode layer and without requiring a cumbersome control of the atmosphere. In this case, when the calcination-reaching temperature $T_1$ is in the range of 900°C to 1000°C, for example, the oxygen partial pressure at this temperature in the range of $1 \times 10^{-6}$ Pa to $1 \times 10^{-11}$ atm.

Preferably, an atmospheric gas having an oxide partial pressure $p(O_2)$ with the range shown in Formula (6) below is introduced when the temperature has reached 100°C or more. More preferably, an atmospheric gas of such an oxide partial pressure as being an oxide partial pressure under which metal copper and lead oxide can coexist at the calcination-reaching temperature $T_1$ is introduced when the temperature has reached 100°C or more. The preferable range is shown by line "e" [$p(O_2) = 10^6 \times Kp^2$] and line "f" [$p(O_2) = 10^8 \times Kp^2$] in FIG. 4. In this case, the oxygen partial pressure at the calcination-reaching temperature $T_1$ (900°C to 1000°C) becomes approximately $1 \times 10^{-7}$ Pa to $2 \times 10^{-10}$ Pa.

$$10^6 \times Kp^2 \leq p(O_2) \leq 10^8 \times Kp^2 \qquad (6)$$

wherein Kp stands for the dissociation equilibrium constant of water, and the unit of $p(O_2)$ is Pa.

After the introduction of the atmospheric gas, calcination is performed in accordance with the temperature profile shown in FIG. 3. At this time, no change of the atmospheric required at all. Calcination is performed, with the set atmospheric gas retained. Therefore, no cumbersome control of the atmosphere is required, and the productivity can be enhanced. Furthermore, since there is no case making the device configuration cumbersome and complicated and making the in-furnace atmosphere at the time of temperature elevation uneven, it is made possible to produce products of homogenous quality.

Preferred embodiments to which the present invention is applied will be described below with reference to experimental results.

Experiment 1-1: Experiment for confirming the effect of addition of a first accessory ingredient (MnO), in which Mn was added to a chief ingredient of $(Pb_{0.995-0.03}Sr_{0.03})[(Zn_{1/3}Nb_{2/3})_{0.1}Ti_{0.43}Zr_{0.47}]O_3$ so that the Mn content was as shown in Table 1 below in terms of MnO:

A piezoelectric ceramic composition was produced by the following procedure. First, as raw materials for a chief ingredient, PbO powder, $SrCO_3$ powder, ZnO powder, $Nb_2O_5$ powder, $TiO_2$ powder and $ZrO_2$ powder were prepared and weighed out so that the chief ingredient had the aforementioned composition. Then, $MnCO_3$ was prepared as an additive Mn species and added to the matrix composition of the chief ingredient so that the Mn content was as shown in Table 1 below in terms of MnO. These raw materials were wet-mixed with a ball mill for 16 hours and calcined in the air at a temperature in the range of 700°C to 900°C for two hours.

The calcined body thus obtained was pulverized and then wet-pulverized with a ball mill for 16 hours. The wet-pulverized grains were dried, added with acrylic resin as a binder, pelletized and molded under a pressure of around 445 MPa using a uniaxial press molding machine into a disc 17 mm in diameter and 1 mm in thickness. The disc was heat-treated to volatilize the binder and fired in a hypoxic reducing atmosphere (of an oxygen partial pressure in the range of $1 \times 10^{-10}$ to $1 \times 10^{-6}$ atm.) at 900°C for a period in the range of two to eight hours. The sintered body thus obtained was subjected to a slicing process and a lapping process into discs each having a thickness of 0.6 mm. Each disc was printed on the opposite surfaces with silver paste, seized at 300°C and applied with an electric field of 3 kV in silicone oil heated to 120°C, thereby undergoing a poling process.

Samples of Examples 1-1 to 1-6 and Comparative Examples 1-1 and 1-2 were produced in accordance with the method described above, with the amount of Mn (MnO) to be added varied so that the amount might be as shown in Table 1 below.

The electrical resistance and electromechanical coupling factor kr of each sample of the examples and comparative examples were measured. The electromechanical coupling factor kr was measured with an impedance analyzer (produced by Hewlett-Packard Co. under the product code of HP4194A). The results thereof are shown in Table 1 below. It is noted that the electrical resistance IR (relative value) means the value obtained by dividing the resistance value of each sample at 150°C by the resistance value at 150°C in the case of no additive (Comparative Example 1-1).

Table 1

| | Mn content in terms of MnO (mass%) | Electrical resistance IR (relative value) | Electromechanical coupling factor kr (%) |
|---|---|---|---|
| Ex. 1-1 | 0.005 | 2.1 | 68.8 |
| Ex. 1-2 | 0.01 | 4.3 | 68.7 |
| Ex. 1-3 | 0.03 | 40.7 | 65.7 |
| Ex. 1-4 | 0.05 | 38.3 | 65.1 |
| Ex. 1-5 | 0.1 | 70.3 | 62.2 |
| Ex. 1-6 | 0.2 | 29.8 | 58.0 |
| Comp. Ex. 1-1 | 0 | 1.0 | 68.9 |
| Comp. Ex. 1-2 | 0.3 | 24.8 | 47.4 |

It is clearly found from Table 1 above that the addition of MnO that is the first accessory ingredient enables the electrical resistance at high temperatures to be greatly improved in comparison with the sample of Comparative Example 1-1 having no first accessory ingredient added thereto. When the content of MnO is unduly large as in the sample of Comparative Example 1-2, however, the degree of improvement in the electrical resistance at high temperatures is lowered, and the electromechanical coupling factor kr is so lowered as to fall short of 50% as the standard value. Therefore, it can be said that preferably the CuO is added so that the content thereof may be 0.2 mass% or less.

Experiment 1-2: Study on the composition "a" of the element at the A-site in a chief ingredient of $(Pb_{a-0.03}Sr_{0.03})[(Zn_{1/3}Nb_{2/3})_{0.1}Ti_{0.43}Zr_{0.47}]O_3$ (first accessory ingredient: Mn):

Samples of Examples 1-7 to 1-10 were produced, with the composition "a" in the chief ingredient varied. The production method of the piezoelectric ceramic composition in this experiment was the same as that in Experiment 1-1. The electrical resistance IR (relative value) and electromechanical coupling factor kr of each sample of these examples were measured in the same manner as in Experiment 1-1. The results thereof are shown in Table 2 below.

Table 2

| | Composition "a" in chief ingredient | Mn content in terms of MnO (mass%) | Electrical resistance IR (relative value) | Electromechanical coupling factor kr (%) |
|---|---|---|---|---|
| Ex.1-7 | 0.96 | 0.05 | 4.4 | 56.5 |
| Ex.1-8 | 0.995 | 0.05 | 38.3 | 65.1 |
| Ex. 1-9 | 1.005 | 0.05 | 41.2 | 62.9 |
| Ex. 1-10 | 1.03 | 0.05 | 26.5 | 57.6 |

As is clear from Table 2 above, the effect of the addition of MnO can also be obtained when the composition "a" is varied within the range prescribed in the present invention. In any of the samples, the electrical resistance at high temperatures is greatly improved, and the electromechanical coupling factor kr is suppressed from being lowered. Experiment 1-3: Study on the composition "b" of the element at the A-site in a chief ingredient of $(Pb_{0.995-b}Sr_b)[(Zn_{1/3}Nh_{2/3})_{0.1}Ti_{0.43}Zr_{0.47}]O_3$ (first accessory ingredient: Mn):

Samples of Examples 1-11 to 1-15 were produced, with the composition "b" in the chief ingredient varied. The production method of the piezoelectric ceramic composition in this experiment was the same as that in Experiment 1-1. The electrical resistance IR (relative value) and electromechanical coupling factor kr of each sample of these examples were measured in the same manner as in Experiment 1-1 or Experiment 1-2. The results thereof are shown in Table 3 below.

Table 3

|  | Composition "b" in chief ingredient | Mn content in terms of MnO (mass%) | Electrical resistance IR (relative value) | Electromechanical coupling factor kr (%) |
|---|---|---|---|---|
| Ex. 1-11 | 0 | 0.05 | 40.8 | 56.8 |
| Ex. 1.12 | 0.01 | 0.05 | 40.3 | 64.9 |
| Ex. 1-13 | 0.03 | 0.05 | 38.3 | 65.1 |
| Ex. 1-14 | 0.06 | 0.05 | 36.1 | 64.1 |
| Ex. 1-15 | 0.1 | 0.05 | 27.3 | 59.0 |

As is clear from Table 3 above, the effect of the addition of MnO can also be obtained when the composition "b" is varied within the range prescribed in the present invention. In any of the samples, the electrical resistance at high temperatures is greatly improved, and the electromechanical coupling factor kr is suppressed from being lowered.

Experiment 1-4: Study on substituted element Me at the A-site in a chief ingredient of $(Pb_{0.995-0.03}Me_{0.03})[(Zn_{1/3}Nb_{2/3})_{0.1}Ti_{0.43}Zr_{0.47}]O_3$ (first accessory ingredient: Mn):

Samples of Examples 1-16 and 1-17 were produced in the same manner as in Experiment 1-1, with the substituted element Me changed to Ca or Ba. The results of measurements of the electrical resistance IR (relative value) at high temperatures and the electromechanical coupling factor kr are shown in Table 4 below.

Table 4

|  | Composition "Me" in chief ingredient | Mn content in terms of MnO (mass%) | Electrical resistance IR (relative value) | Electromechanical coupling factor kr (%) |
|---|---|---|---|---|
| Ex.1-16 | Ca | 0.05 | 41.5 | 61.1 |
| Ex.1-17 | Ba | 0.05 | 32.7 | 62.8 |

As is clear from Table 4 above, the effect of the addition of MnO can also be obtained when the substituted element Me is changed from Sr to Ca or Ba. The electrical resistance at high temperatures is greatly improved, and the electromechanical coupling factor kr is suppressed from being lowered.

Experiment 1-5: Study on the compositions x, y and z of the elements at the B-site in a chief ingredient of $(Pb_{a\cdot0.03}Sr_{0.03})[(Zn_{1/3}Nb_{2/3})_xTi_yZr_z]O_3$ (first accessory ingredient: Mn):

Samples of Examples 1-18 to 1-23 and Comparative Experiment 1-2 were produced, with the compositions x, y and z of the elements at the B-site in the chief ingredient varied. The production method of the piezoelectric ceramic composition in this experiment was the same as that in Experiment 1-1. The electrical resistance IR (relative value) and electromechanical coupling factor kr of each sample of these examples were measured in the same manner as in Experiment 1-1. The results thereof are shown in Table 5 below.

Table 5

|  | Compositions in chief ingredient | | | Mn content in terms of MnO (mass%) | Electrical resistance IR (relative value) | Electromechanical coupling factor kr (%) |
|---|---|---|---|---|---|---|
|  | x | y | z | | | |
| Comp. Ex.1-2 | 0.00 | 0.48 | 0.52 | 0.05 | 34.1 | 33.2 |
| Ex.1-18 | 0.05 | 0.43 | 0.52 | 0.05 | 39.6 | 65.0 |
| Ex. 1-19 | 0.05 | 0.50 | 0.45 | 0.05 | 3.1 | 63.0 |
| Ex. 1-20 | 0.10 | 0.43 | 0.47 | 0.05 | 38.3 | 65.1 |
| Ex. 1-21 | 0.10 | 0.45 | 0.45 | 0.05 | 23.2 | 62.0 |

(continued)

| | Compositions in chief ingredient | | | Mn content in terms of MnO (mass%) | Electrical resistance IR (relative value) | Electromechanical coupling factor kr (%) |
|---|---|---|---|---|---|---|
| | x | y | z | | | |
| Ex. 1-22 | 0.10 | 0.50 | 0.40 | 0.05 | 15.0 | 59.6 |
| Ex. 1-23 | 0.15 | 0.45 | 0.40 | 0.05 | 39.5 | 61.5 |

It is clearly found from Table 5 above that the effect of the addition of MnO can also be obtained when the compositions x, y and z of the elements at the B-site are varied as shown in Table 5 above, that the electrical resistance at high temperatures is greatly improved and that the electromechanical coupling factor kr is suppressed from being lowered. In Comparative Example 1-2 in which the compositions x, y and z of the elements at the B-site fall outside the ranges prescribed in the present invention, however, the electromechanical coupling factor kr is small, i.e. below the standard value (50%).

Experiment 1-6: Study on addition of the second accessory ingredient ($Ta_2O_5$) (first accessory ingredient: Mn):

Samples of Examples 1-24 to 1-29 were produced, with $Ta_2O_5$ added as a second accessory ingredient and the amount thereof varied as shown in Table 6 below. The production method of the piezoelectric ceramic composition was the same as that in Experiment 1-1. The electrical resistance IR (relative value) and electromechanical coupling factor kr of each sample of these examples were measured in the same manner as in Experiment 1-1. The results thereof are shown in Table 6 below.

Table 6

| | Accessory ingredient composition | | Electrical resistance IR (relative value) | Electromechanical coupling factor kr (%) |
|---|---|---|---|---|
| | Mn content in terms of MnO (mass%) | $Ta_2O_5$ content (mass%) | | |
| Ex.1-24 | 0.05 | 0.0 | 36.1 | 62.9 |
| Ex. 1-25 | 0.05 | 0.1 | 45.4 | 64.3 |
| Ex. 1-26 | 0.05 | 0.2 | 38.3 | 65.1 |
| Ex. 1-27 | 0.05 | 0.4 | 31.3 | 63.7 |
| Ex. 1-28 | 0.05 | 0.6 | 24.2 | 61.8 |
| Ex. 1-29 | 0.05 | 1.0 | 10.6 | 51.0 |

As is clear from Table 6 above, where $Ta_2O_5$ is added as the second accessory ingredient, the effect of the addition of MnO can also be obtained, the electrical resistance at high temperatures is greatly improved, and the electromechanical coupling factor kr is suppressed from being lowered. However, a large amount of $Ta_2O_5$ added shows a tendency for both the hot load life and the electromechanical coupling factor kr to go down slightly.

Experiment 1-7: Study on the kind of the second accessory ingredient (first accessory ingredient: Mn):

Samples of Examples 1-30 to 1-34 were produced, with the oxides shown in Table 7 below added in the respective amounts shown in Table 7 below. The production method of the piezoelectric ceramic composition is the same as that in Experiment 1-1. The electrical resistance IR (relative value) at high temperatures and electromechanical coupling factor kr of each sample of these examples were measured in the same manner as in Experiment 1-1. The results thereof are shown in Table 7 below.

Table 7

| | First accessory ingredient | | Second accessory ingredient | | Electrical resistance IR (relative value) | Electromechanical coupling factor kr (%) |
|---|---|---|---|---|---|---|
| | Kind | Content (mass%) | Kind | Content (mass%) | | |
| Ex. 1-30 | MnO | 0.05 | $Sb_2O_3$ | 0.3 | 2.7 | 67.0 |
| Ex.1-31 | MnO | 0.05 | $Nb_2O_5$ | 0.1 | 17.7 | 69.8 |
| Ex.1-32 | MnO | 0.05 | $WO_3$ | 0.05 | 4.1 | 66.2 |
| Ex. 1-33 | MnO | 0.05 | $WO_3$ | 0.1 | 5.9 | 66.1 |
| Ex.1-34 | MnO | 0.05 | $WO_3$ | 0.5 | 4.2 | 65.1 |

It is clearly found from Table 7 above that any of the additives added in any of the amounts is effective, that the electrical resistance at high temperatures is high and that the electromechanical coupling factor kr is high.

Experiment 2-1: Experiment for confirming the effect of the addition of the first accessory ingredient (CoO) to a chief ingredient of $(Pb_{0.995-0.03}Sr_{0.03})$ $[(Zn_{1/3}Nb_{2/3})_{0.1}Ti_{0.43}Zr_{0.47}]O_3$:

Samples of Examples 2-1 to 2-5 and Comparative Examples 2-1 and 2-2 were produced, with Co added to the chief ingredient so that the Co content might be as shown in Table 8 below in terms of CoO. The production method of the piezoelectric ceramic composition in this experiment was the same as that in Experiment 1-1, and CoO was used as the material for the first accessory ingredient. The electrical resistance IR (relative value) at high temperatures and electromechanical coupling factor kr of each sample of these examples were measured. The results thereof are shown in Table 8 below.

Table 8

| | Co content in terms of CoO (mass%) | Electrical resistance IR (relative value) | Electromechanical coupling factor kr (%) |
|---|---|---|---|
| Ex. 2-1 | 0.005 | 1.2 | 68.9 |
| Ex. 2-2 | 0.01 | 2.5 | 67.6 |
| Ex. 2-3 | 0.05 | 15.0 | 67.3 |
| Ex. 2-4 | 0.1 | 20.9 | 60.2 |
| Ex. 2-5 | 0.2 | 1.5 | 55.6 |
| Comp. Ex. 2-1 | 0 | 0.9 | 68.9 |
| Comp. Ex. 2-2 | 0.3 | 1.0 | 51.2 |

It is clearly found from Table 8 above that the addition of CoO that is the first accessory ingredient enables the electrical resistance at high temperatures to be greatly improved in comparison with the sample of Comparative Example 2-1 having no first accessory ingredient added thereto. When the content of CoO is unduly large as in the sample of Comparative Example 2-2, however, the degree of improvement in the electrical resistance IR at high temperatures is greatly lowered. Therefore, it can be said that preferably the CoO is added so that the content thereof may be 0.2 mass% or less.

Experiment 2-2: Study on the composition "a" of the element at the A-site in a chief ingredient of $(Pb_{a·0.03}Sr_{0.03})[(Zn_{1/3}Nb_{2/3})_{0.1}Ti_{0.43}Zr_{0.47}]O_3$ (first accessory ingredient: Co):

Samples of Examples 2-6 to 2-9 were produced, with the composition "a" in the chief ingredient varied. The production method of the piezoelectric ceramic composition in this experiment was the same as that in Experiment 2-1. The electrical resistance IR (relative value) and electromechanical coupling factor kr of each sample of these examples were measured in the same manner as in Experiment 2-1. The results thereof are shown in Table 9 below.

Table 9

| | Composition "a" in chief ingredient | Co content in terms of CoO (mass%) | Electrical resistance IR (relative value) | Electromechanical coupling factor kr (%) |
|---|---|---|---|---|
| Ex. 2-6 | 0.96 | 0.05 | 1.7 | 58.5 |
| Ex. 2-7 | 0.995 | 0.05 | 15.0 | 67.3 |
| Ex. 2-8 | 1.005 | 0.05 | 16.1 | 65.1 |
| Ex. 2-9 | 1.03 | 0.05 | 10.3 | 59.5 |

As is clear from Table 9 above, the effect of the addition of CoO can also be obtained when the composition "a" is varied within the range prescribed in the present invention. In any of the samples, the electrical resistance at high temperatures is greatly improved, and the electromechanical coupling factor kr is suppressed from being lowered.

Experiment 2-3: Study on the composition "b" of the element at the A-site in a chief ingredient of $(Pb_{0.995-b}Sr_b)[(Zn_{1/3}Nb_{2/3})_{0.1}Ti_{0.43}Zr_{0.47}]O_3$ (first accessory ingredient: Co):

Samples of Examples 2-10 to 2-14 were produced, with the composition "b" in the chief ingredient varied. The production method of the piezoelectric ceramic composition in this experiment was the same as that in Experiment 2-1. The electrical resistance IR (relative value) and electromechanical coupling factor kr of each sample of these examples were measured in the same manner as in Experiment 2-1. The results thereof are shown in Table 10 below.

Table 10

| | Composition "b" in chief ingredient | Co content in terms of CoO (mass%) | Electrical Resistance IR (relative value) | Electromechanical coupling factor kr (%) |
|---|---|---|---|---|
| Ex. 2-10 | 0 | 0.05 | 15.9 | 58.8 |
| Ex. 2·11 | 0.01 | 0.05 | 15.8 | 67.1 |
| Ex. 2-12 | 0.03 | 0.05 | 15.0 | 67.3 |
| Ex. 2-13 | 0.06 | 0.05 | 14.1 | 66.3 |
| Ex. 2-14 | 0.1 | 0.05 | 10.7 | 61.0 |

As is clear from Table 10 above, the effect of the addition of CoO can also be obtained when the composition "b" is varied within the range prescribed in the present invention. In any of the samples, the electrical resistance at high temperatures is greatly improved, and the electromechanical coupling factor kr is suppressed from being lowered.

Experiment 2-4: Study on substituted element Me at the A-site in a chief ingredient of $(Pb_{0.995-0.03}Me_{0.03})[(Zn_{1/3}Nb_{2/3})_{0.1}Ti_{0.43}Zr_{0.47}]O_3$ (first accessory ingredient: Co):

Samples of Examples 2-15 and 2-16 were produced in the same manner as in Experiment 2-1, with the substituted element Me changed to Ca or Ba. The results of measurements of the electrical resistance IR (relative value) at high temperatures and the electromechanical coupling factor kr are shown in Table 11 below.

Table 11

| | Composition Me in chief ingredient | Co content in terms of CoO (mass%) | Electrical resistance IR (relative value) | Electromechanical coupling factor kr (%) |
|---|---|---|---|---|
| Ex. 2-15 | Ca | 0.05 | 16.2 | 66.1 |
| Ex. 2-16 | Ba | 0.05 | 12.8 | 67.2 |

As is clear from Table 11 above, the effect of the addition of CoO can also be obtained when the substituted element Me is changed from Sr to Ca or Ba. The electrical resistance at high temperatures is greatly improved, and the electromechanical coupling factor kr is suppressed from being lowered.

Experiment 2-5: Study on the compositions x, y and z of the elements at the B-site in a chief ingredient of $(Pb_{a-0.03}Sr_{0.03})[(Zn_{1/3}Nb_{2/3})_xTi_yZr_z]O_3$ (first accessory ingredient: Co):

Samples of Examples 2-17 to 2-22 and Comparative Experiment 2-2 were produced, with the compositions x, y and z of the elements at the B-site in the chief ingredient varied as shown in Table 12 below. The production method of the piezoelectric ceramic composition in this experiment was the same as that in Experiment 2-1. The electrical resistance IR (relative value) and electromechanical coupling factor kr of each sample of these examples were measured in the same manner as in Experiment 2-1. The results thereof are shown in Table 12 below.

Table 12

| | Compositions in chief ingredient | | | Co content in terms of CoO (mass%) | Electrical resistance IR (relative value) | Electromechanical coupling factor kr (%) |
|---|---|---|---|---|---|---|
| | x | y | z | | | |
| Comp. Ex. 2-2 | 0.00 | 0.48 | 0.52 | 0.05 | 13.3 | 34.4 |
| Ex. 2-17 | 0.05 | 0.43 | 0.52 | 0.05 | 15.5 | 67.2 |
| Ex. 2-18 | 0.05 | 0.50 | 0.45 | 0.05 | 1.2 | 65.2 |
| Ex. 2-19 | 0.10 | 0.43 | 0.47 | 0.05 | 15.0 | 67.3 |
| Ex. 2-20 | 0.10 | 0.45 | 0.45 | 0.05 | 9.1 | 64.1 |
| Ex. 2-21 | 0.10 | 0.50 | 0.40 | 0.05 | 5.9 | 61.7 |
| Ex. 2-22 | 0.15 | 0.45 | 0.40 | 0.05 | 15.4 | 63.6 |

It is clearly found from Table 12 above that the effect of the addition of CoO can also be obtained when the compositions x, y and z of the elements at the B-site are varied, that the electrical resistance at high temperatures is greatly improved and that the electromechanical coupling factor kr is suppressed from being lowered. In Comparative Example 2-2 in which the compositions x, y and z of the elements at the B-site fall outside the ranges prescribed in the present invention, however, the electromechanical coupling factor kr is small, i.e. below the standard value (50%).

Experiment 2-6: Study on addition of the second accessory ingredient $(Ta_2O_5)$ (first accessory ingredient: Co):

Samples of Examples 2-23 to 2-28 were produced, with $Ta_2O_5$ added as a second accessory ingredient and the amount thereof varied as shown in Table 13 below. The production method of the piezoelectric ceramic composition was the same as that in Experiment 2-1. The electrical resistance IR (relative value) at high temperatures and electromechanical coupling factor kr of each sample of these examples were measured in the same manner as in Experiment 2-1. The results thereof are shown in Table 13 below.

Table 13

| | Accessory ingredient composition | | Electrical resistance IR (relative value) | Electromechanical coupling factor kr (%) |
|---|---|---|---|---|
| | Co content in terms of CoO (mass%) | $Ta_2O_5$ content (mass%) | | |
| Ex. 2-23 | 0.05 | 0.0 | 14.1 | 65.0 |
| Ex. 2-24 | 0.05 | 0.1 | 17.8 | 66.5 |
| Ex. 2-25 | 0.05 | 0.2 | 15.0 | 67.3 |
| Ex. 2-26 | 0.05 | 0.4 | 12.2 | 65.9 |
| Ex. 2-27 | 0.05 | 0.6 | 9.5 | 63.9 |
| Ex. 2-28 | 0.05 | 1.0 | 4.2 | 52.7 |

As is clear from Table 13 above, where $Ta_2O_5$ is added as the second accessory ingredient, the effect of the addition of CoO can also be obtained, the electrical resistance at high temperatures is greatly improved, and the electromechanical coupling factor kr is suppressed from being lowered. However, a large amount of $Ta_2O_5$ added shows a tendency for both the hot load life and the electromechanical coupling factor kr to go down slightly.

Experiment 2-7: Study on the kind of the second accessory ingredient (first accessory ingredient: Co):

Samples of Examples 2-29 to 2-33 were produced, with the oxides shown in Table 14 below added in the respective amounts shown in Table 14 below. The production method of the piezoelectric ceramic composition is the same as that in Experiment 2-1. The electrical resistance IR (relative value) at high temperatures and electromechanical coupling factor kr of each sample of these examples were measured in the same manner as in Experiment 2-1. The results thereof are shown in Table 14 below.

Table 14

| | First accessory ingredient | | Second accessory ingredient | | Electrical resistance IR (relative value) | Electromechanical coupling factor kr (%) |
|---|---|---|---|---|---|---|
| | Kind | Content (mass%) | Kind | Content (mass%) | | |
| Ex.2-29 | CoO | 0.05 | $Sb_2O_3$ | 0.3 | 1.1 | 67.0 |
| Ex. 2-30 | CoO | 0.05 | $Nb_2O_5$ | 0.1 | 6.9 | 69.8 |
| Ex.2-31 | CoO | 0.05 | $WO_3$ | 0.05 | 1.6 | 66.2 |
| Ex.2-32 | CoO | 0.05 | $WO_3$ | 0.1 | 2.3 | 66.1 |
| Ex.2-33 | CoO | 0.05 | $WO_3$ | 0.5 | 1.7 | 65.1 |

It is clearly found from Table 14 above that any of the additives added in any of the amounts is effective, that the electrical resistance at high temperatures is high and that the electromechanical coupling factor kr is high.

Experiment 3-1: Experiment for confirming the effect of the addition of the first accessory ingredient (CrO) to a chief ingredient of $(Pb_{0.995-0.03}Sr_{0.03})$ $[(Zn_{1/3}Nb_{2/3})_{0.1}Ti_{0.43}Zr_{0.47}]O_3$:

Samples of Examples 3-1 to 3-6 and Comparative Examples 3-1 and 3-2 were produced, with Cr added to the chief ingredient so that the Cr content might be as shown in Table 15 below in terms of CrO. The production method of the piezoelectric ceramic composition in this experiment was the same as that in Experiment 1-1, and $Cr_2O_3$ was used as the material for the first accessory ingredient. The electrical resistance IR (relative value) at high temperatures and electromechanical coupling factor kr of each sample of these examples were measured. The results thereof are shown in Table 15 below.

Table 15

| | Cr content in terms of CrO (mass%) | Electrical resistance IR (relative value) | Electromechanical coupling factor kr (%) |
|---|---|---|---|
| Ex. 3-1 | 0.005 | 1.2 | 66.9 |
| Ex. 3-2 | 0.01 | 1.8 | 64.0 |
| Ex. 3-3 | 0.03 | 7.1 | 66.4 |
| Ex. 3-4 | 0.05 | 7.0 | 69.3 |
| Ex. 3-5 | 0.1 | 6.4 | 64.5 |
| Ex. 3-6 | 0.2 | 3.3 | 60.3 |
| Comp. Ex. 3-1 | 0 | 1.0 | 68.9 |
| Comp. Ex. 3-2 | 0.3 | 0.2 | 58.3 |

It is clearly found from Table 15 above that the addition of CrO that is the first accessory ingredient enables the electrical resistance at high temperatures to be greatly improved in comparison with the sample of Comparative Example 3-1 having no first accessory ingredient added thereto. When the content of CrO is unduly large as in the sample of Comparative Example 3-2, however, the degree of improvement in the electrical resistance IR at high temperatures is greatly lowered. Therefore, it can be said that preferably the CrO is added so that the content thereof may be 0.2 mass% or less.

Experiment 3-2: Study on the composition "a" of the element at the A-site in a chief ingredient of $(Pb_{a-0.03}Sr_{0.03})[(Zn_{1/3}Nb_{2/3})_{0.1}Ti_{0.43}Zr_{0.47}]O_3$ (first accessory ingredient: Cr):

Samples of Examples 3-7 to 3-10 were produced, with the composition "a" in the chief ingredient varied. The production method of the piezoelectric ceramic composition in this experiment was the same as that in Experiment 3-1. The electrical resistance IR (relative value) and electromechanical coupling factor kr of each sample of these examples were measured in the same manner as in Experiment 3-1. The results thereof are shown in Table 16 below.

Table 16

| | Composition "a" in chief ingredient | Cr content in terms of CrO (mass%) | Electrical resistance IR (relative value) | Electromechanical coupling factor kr (%) |
|---|---|---|---|---|
| Ex. 3-7 | 0.96 | 0.05 | 1.1 | 60.1 |
| Ex. 3-8 | 0.995 | 0.05 | 7.0 | 69.3 |
| Ex. 3-9 | 1.005 | 0.05 | 7.6 | 67.0 |
| Ex. 3-10 | 1.03 | 0.05 | 4.9 | 61.2 |

As is clear from Table 16 above, the effect of the addition of CrO can also be obtained when the composition "a" is varied within the range prescribed in the present invention. In any of the samples, the electrical resistance at high temperatures is greatly improved, and the electromechanical coupling factor kr is suppressed from being lowered.

Experiment 3-3: Study on the composition "b" of the element at the A-site in a chief ingredient of $(Pb_{0.995-b}Sr_b)[(Zn_{1/3}Nb_{2/3})_{0.1}Ti_{0.43}Zr_{0.47}]O_3$ (first accessory ingredient: Cr):

Samples of Examples 3-11 to 3-15 were produced, with the composition "b" in the chief ingredient varied. The production method of the piezoelectric ceramic composition in this experiment was the same as that in Experiment 3-1. The electrical resistance IR (relative value) and electromechanical coupling factor kr of each sample of these examples were measured in the same manner as in Experiment 3-1. The results thereof are shown in Table 17 below.

Table 17

| | Composition "b" in chief ingredient | Cr content in terms of CrO (mass%) | Electrical resistance IR (relative value) | Electromechanical coupling factor kr (%) |
|---|---|---|---|---|
| Ex. 3-11 | 0 | 0.05 | 7.5 | 60.4 |
| Ex. 3-12 | 0.01 | 0.05 | 7.4 | 69.1 |
| Ex. 3-13 | 0.03 | 0.05 | 7.0 | 69.3 |
| Ex. 3-14 | 0.06 | 0.05 | 6.6 | 68.2 |
| Ex.3-15 | 0.1 | 0.05 | 5.0 | 62.7 |

As is clear from Table 17 above, the effect of the addition of CrO can also be obtained when the composition "b" is varied within the range prescribed in the present invention. In any of the samples, the electrical resistance at high temperatures is greatly improved, and the electromechanical coupling factor kr is suppressed from being lowered.

Experiment 3-4: Study on substituted element Me at the A-site in a chief ingredient of $(Pb_{0.995-0.03}Me_{0.03})[(Zn_{1/3}Nb_{2/3})_{0.1}Ti_{0.43}Zr_{0.47}]O_3$ (first accessory ingredient: Cr):

Samples of Examples 3-16 and 3-17 were produced in the same manner as in Experiment 3-1, with the substituted element Me changed to Ca or Ba. The results of measurements of the electrical resistance IR (relative value) at high temperatures and the electromechanical coupling factor kr are shown in Table 18 below.

Table 18

|  | Composition Me in chief ingredient | Cr content in terms of CrO (mass%) | Electrical resistance IR (relative value) | Electromechanical coupling factor kr (%) |
|---|---|---|---|---|
| Ex.3-16 | Ca | 0.05 | 7.6 | 65.0 |
| Ex. 3-17 | Ba | 0.05 | 6.0 | 66.8 |

As is clear from Table 18 above, the effect of the addition of CrO can also be obtained when the substituted element Me is changed from Sr to Ca or Ba. The electrical resistance at high temperatures is greatly improved, and the electromechanical coupling factor kr is suppressed from being lowered.

Experiment 3-5: Study on the compositions x, y and z of the elements at the B-site in a chief ingredient of $(Pb_{a\cdot0.03}Sr_{0.03})[(Zn_{1/3}Nb_{2/3})_xTi_yZr_z]O_3$ (first accessory ingredient: Cr):

Samples of Examples 3-18 to 3-23 and Comparative Experiment 3-2 were produced, with the compositions x, y and z of the elements at the B-site in the chief ingredient varied as shown in Table 19 below. The production method of the piezoelectric ceramic composition in this experiment was the same as that in Experiment 3-1. The electrical resistance IR (relative value) at high temperatures and electromechanical coupling factor kr of each sample of these examples were measured in the same manner as in Experiment 3-1. The results thereof are shown in Table 19 below.

Table 19

|  | Compositions in chief ingredient | | | Cr content in terms of CrO (mass%) | Electrical resistance IR (relative value) | Electromechanical coupling factor kr (%) |
|---|---|---|---|---|---|---|
|  | x | y | z |  |  |  |
| Comp. Ex.3-2 | 0.00 | 0.48 | 0.52 | 0.05 | 6.3 | 35.3 |
| Ex. 3-18 | 0.05 | 0.43 | 0.52 | 0.05 | 7.3 | 69.2 |
| Ex.3-19 | 0.05 | 0.50 | 0.45 | 0.05 | 0.6 | 67.1 |
| Ex. 3-20 | 0.10 | 0.43 | 0.47 | 0.05 | 7.0 | 69.3 |
| Ex. 3-21 | 0.10 | 0.45 | 0.45 | 0.05 | 4.3 | 66.0 |
| Ex. 3-22 | 0.10 | 0.50 | 0.40 | 0.05 | 2.8 | 63.5 |
| Ex. 3-23 | 0.15 | 0.45 | 0.40 | 0.05 | 7.2 | 65.5 |

It is clearly found from Table 19 above that the effect of the addition of CrO can also be obtained when the compositions x, y and z of the elements at the B-site are varied, that the electrical resistance at high temperatures is greatly improved and that the electromechanical coupling factor kr is suppressed from being lowered. In Comparative Example 3-2 in which the compositions x, y and z of the elements at the B-site fall outside the ranges prescribed in the present invention, however, the electromechanical coupling factor kr is small, i.e. below the standard value (50%).

Experiment 3-6: Study on addition of the second accessory ingredient ($Ta_2O_5$) (first accessory ingredient: Cr):

Samples of Examples 3-24 to 3-29 were produced, with $Ta_2O_5$ added as a second accessory ingredient and the amount thereof varied as shown in Table 20 below. The production method of the piezoelectric ceramic composition was the same as that in Experiment 3-1. The electrical resistance IR (relative value) at high temperatures and electromechanical coupling factor kr of each sample of these examples were measured in the same manner as in Experiment 3-1. The results thereof are shown in Table 20 below.

Table 20

|  | Accessory ingredient Composition | | Electrical resistance IR (relative value) | Electromechanical coupling factor kr (%) |
|---|---|---|---|---|
|  | Cr content in terms of CrO (mass%) | $Ta_2O_5$ content (mass%) |  |  |
| Ex. 3-24 | 0.05 | 0.0 | 6.6 | 66.9 |

(continued)

| | Accessory ingredient Composition | | Electrical resistance IR (relative value) | Electromechanical coupling factor kr (%) |
|---|---|---|---|---|
| | Cr content in terms of CrO (mass%) | $Ta_2O_5$ content (mass%) | | |
| Ex. 3-25 | 0.05 | 0.1 | 8.3 | 68.4 |
| Ex.3-26 | 0.05 | 0.2 | 7.0 | 69.3 |
| Ex.3-27 | 0.05 | 0.4 | 5.7 | 67.8 |
| Ex.3-28 | 0.05 | 0.6 | 4.4 | 65.8 |
| Ex. 3-29 | 0.05 | 1.0 | 1.9 | 54.2 |

As is clear from Table 20 above, where $Ta_2O_5$ is added as the second accessory ingredient, the effect of the addition of CoO can also be obtained, the electrical resistance at high temperatures is greatly improved, and the electromechanical coupling factor kr is suppressed from being lowered. However, a large amount of $Ta_2O_5$ added shows a tendency for both the hot load life and the electromechanical coupling factor kr to go down slightly.

Experiment 3-7: Study on the kind of the second accessory ingredient (first accessory ingredient: Cr):

Samples of Examples 3-30 to 3-34 were produced, with the oxides shown in Table 21 below added in the respective amounts shown in Table 21 below. The production method of the piezoelectric ceramic composition is the same as that in Experiment 3-1. The electrical resistance IR (relative value) at high temperatures and electromechanical coupling factor kr of each sample of these examples were measured in the same manner as in Experiment 3-1. The results thereof are shown in Table 21 below.

Table 21

| | First accessory ingredient | | Second accessory ingredient | | Electrical resistance IR (relative value) | Electromechanical coupling factor kr (%) |
|---|---|---|---|---|---|---|
| | Kind | Content (mass%) | Kind | Content (mass%) | | |
| Ex. 3-30 | CrO | 0.05 | $Sb_2O_3$ | 0.3 | 1.2 | 71.3 |
| Ex. 3-31 | CrO | 0.05 | $Nb_2O_5$ | 0.1 | 6.5 | 74.3 |
| Ex. 3-32 | CrO | 0.05 | $WO_3$ | 0.05 | 1.5 | 70.4 |
| Ex. 3-33 | CrO | 0.05 | $WO_3$ | 0.1 | 2.2 | 70.3 |
| Ex. 3-34 | CrO | 0.05 | $WO_3$ | 0.5 | 1.6 | 69.3 |

It is clearly found from Table 21 above that any of the additives added in any of the amounts is effective, that the electrical resistance at high temperatures is high and that the electromechanical coupling factor kr is large.

Experiment 4-1: Experiment for confirming the effect of the addition of the first accessory ingredient (FeO) to a chief ingredient of $(Pb_{0.995-0.03}Sr_{0.03})[(Zn_{1/3}Nb_{2/3})_{0.1}Ti_{0.43}Zr_{0.47}]O_3$

Samples of Examples 4-1 to 4-6 and Comparative Examples 4-1 and 4-2 were produced, with Fe added to the chief ingredient so that the Fe content might be as shown in Table 22 below in terms of FeO. The production method of the piezoelectric ceramic composition in this experiment was the same as that in Experiment 1-1, and $Fe_2O_3$ was used as the material for the first accessory ingredient. The electrical resistance IR (relative value) at high temperatures and electromechanical coupling factor kr of each sample of these examples were measured. The results thereof are shown in Table 22 below.

Table 22

| | Fe content in terms of FeO (mass%) | Electrical resistance IR (relative value) | Electromechanical coupling factor kr (%) |
|---|---|---|---|
| Ex. 4-1 | 0.005 | 1.1 | 66.2 |
| Ex. 4-2 | 0.01 | 2.6 | 61.2 |
| Ex.4-3 | 0.03 | 27.6 | 65.8 |
| Ex. 4-4 | 0.05 | 38.8 | 68.6 |
| Ex. 4-5 | 0.1 | 27.0 | 62.4 |
| Ex. 4-6 | 0.2 | 4.6 | 58.0 |
| Comp. Ex. 4-1 | 0 | 1.0 | 68.9 |
| Comp. Ex. 4-2 | 0.3 | 0.9 | 58.1 |

It is clearly found from Table 22 above that the addition of FeO that is the first accessory ingredient enables the electrical resistance at high temperatures to be greatly improved in comparison with the sample of Comparative Example 4-1 having no first accessory ingredient added thereto. When the content of FeO is unduly large as in the sample of Comparative Example 4-2, however, the degree of improvement in the electrical resistance IR at high temperatures is greatly lowered. Therefore, it can be said that preferably the FeO is added so that the content thereof may be 0.2 mass% or less.

Experiment 4-2: Study on the composition "a" of the element at the A-site in a chief ingredient of $(Pb_{a\cdot0.03}Sr_{0.03})[(Zn_{1/3}Nb_{2/3})_{0.1}Ti_{0.43}Zr_{0.47}]O_3$ (first accessory ingredient: Fe):

Samples of Examples 4-7 to 4-10 were produced, with the composition "a" in the chief ingredient varied. The production method of the piezoelectric ceramic composition in this experiment was the same as that in Experiment 4-1. The electrical resistance IR (relative value) and electromechanical coupling factor kr of each sample of these examples were measured in the same manner as in Experiment 4-1. The results thereof are shown in Table 23 below.

Table 23

| | Composition "a" in chief ingredient | Fe content in terms of FeO (mass%) | Electrical resistance IR (relative value) | Electromechanical coupling factor kr (%) |
|---|---|---|---|---|
| Ex. 4-7 | 0.96 | 0.05 | 4.4 | 59.6 |
| Ex.4-8 | 0.995 | 0.05 | 38.8 | 68.6 |
| Ex. 4-9 | 1.005 | 0.05 | 41.7 | 66.3 |
| Ex. 4-10 | 1.03 | 0.05 | 26.8 | 60.6 |

As is clear from Table 23 above, the effect of the addition of FeO can also be obtained when the composition "a" is varied within the range prescribed in the present invention. In any of the samples, the electrical resistance at high temperatures is greatly improved, and the electromechanical coupling factor kr is suppressed from being lowered.

Experiment 4-3: Study on the composition "b" of the element at the A-site in a chief ingredient of $(Pb_{0.995-b}Sr_b)[(Zn_{1/3}Nb_{2/3})_{0.1}Ti_{0.43}Zr_{0.47}]O_3$ (first accessory ingredient: Fe):

Samples of Examples 4-11 to 4-15 were produced, with the composition "b" in the chief ingredient varied. The production method of the piezoelectric ceramic composition in this experiment was the same as that in Experiment 4-1. The electrical resistance IR (relative value) and electromechanical coupling factor kr of each sample of these examples were measured in the same manner as in Experiment 4-1. The results thereof are shown in Table 24 below.

Table 24

|  | Composition "b" in chief ingredient | Fe content in terms of FeO (mass%) | Electrical resistance IR (relative value) | Electromechanical coupling factor kr (%) |
|---|---|---|---|---|
| Ex. 4-11 | 0 | 0.05 | 41.3 | 59.8 |
| Ex.4-12 | 0.01 | 0.05 | 40.9 | 68.4 |
| Ex.4-13 | 0.03 | 0.05 | 38.8 | 68.6 |
| Ex. 4-14 | 0.06 | 0.05 | 36.6 | 67.5 |
| Ex. 4-15 | 0.1 | 0.05 | 27.7 | 62.1 |

As is clear from Table 24 above, the effect of the addition of FeO can also be obtained when the composition "b" is varied within the range prescribed in the present invention. In any of the samples, the electrical resistance at high temperatures is greatly improved, and the electromechanical coupling factor kr is suppressed from being lowered.

Experiment 4-4: Study on substituted element Me at the A-site in a chief ingredient of $(Pb_{0.995-0.03}Me_{0.03})[(Zn_{1/3}Nb_{2/3})_{0.1}Ti_{0.43}Zr_{0.47}]O_3$ (first accessory ingredient: Fe):

Samples of Examples 4-16 and 4-17 were produced in the same manner as in Experiment 4-1, with the substituted element Me changed to Ca or Ba. The results of measurements of the electrical resistance IR (relative value) at high temperatures and the electromechanical coupling factor kr are shown in Table 25 below.

Table 25

|  | Composition Me in chief ingredient | Fe content in terms of FeO (mass%) | Electrical resistance IR (relative value) | Electromechanical coupling factor kr (%) |
|---|---|---|---|---|
| Ex. 4-16 | Ca | 0.05 | 42.0 | 64.3 |
| Ex. 4-17 | Ba | 0.05 | 33.1 | 66.1 |

As is clear from Table 25 above, the effect of the addition of FeO can also be obtained when the substituted element Me is changed from Sr to Ca or Ba. The electrical resistance at high temperatures is greatly improved, and the electromechanical coupling factor kr is suppressed from being lowered.

Experiment 4-5: Study on the compositions x, y and z of the elements at the B-site in a chief ingredient of $(Pb_{a-0.03}Sr_{0.03})[(Zn_{1/3}Nb_{2/3})_xTi_yZr_z]O_3$ (first accessory ingredient: Cr):

Samples of Examples 4-18 to 4-23 and Comparative Experiment 4-2 were produced, with the compositions x, y and z of the elements at the B-site in the chief ingredient varied as shown in Table 26 below. The production method of the piezoelectric ceramic composition in this experiment was the same as that in Experiment 4-1. The electrical resistance IR (relative value) at high temperatures and electromechanical coupling factor kr of each sample of these examples were measured in the same manner as in Experiment 4-1. The results thereof are shown in Table 26 below.

Table 26

|  | Compositions in chief ingredient | | | Fe content in terms of FeO (mass%) | Electrical resistance IR (relative value) | Electromechanical coupling factor kr (%) |
|---|---|---|---|---|---|---|
|  | x | y | z |  |  |  |
| Comp. Ex.4-2 | 0.00 | 0.48 | 0.52 | 0.05 | 34.5 | 35.0 |
| Ex.4-18 | 0.05 | 0.43 | 0.52 | 0.05 | 40.1 | 68.5 |
| Ex.4-19 | 0.05 | 0.50 | 0.45 | 0.05 | 3.2 | 66.4 |
| Ex.4-20 | 0.10 | 0.43 | 0.47 | 0.05 | 38.8 | 68.6 |
| Ex.4-21 | 0.10 | 0.45 | 0.45 | 0.05 | 23.5 | 65.3 |
| Ex.4-22 | 0.10 | 0.50 | 0.40 | 0.05 | 15.2 | 62.8 |

(continued)

| | Compositions in chief ingredient | | | Fe content in terms of FeO (mass%) | Electrical resistance IR (relative value) | Electromechanical coupling factor kr (%) |
|---|---|---|---|---|---|---|
| | x | y | z | | | |
| Ex. 4-23 | 0.15 | 0.45 | 0.40 | 0.05 | 40.0 | 64.8 |

It is clearly found from Table 26 above that the effect of the addition of FeO can also be obtained when the compositions x, y and z of the elements at the B-site are varied, that the electrical resistance at high temperatures is greatly improved and that the electromechanical coupling factor kr is suppressed from being lowered. In Comparative Example 4-2 in which the compositions x, y and z of the elements at the B-site fall outside the ranges prescribed in the present invention, however, the electromechanical coupling factor kr is small, i.e. below the standard value (50%).

Experiment 4-6: Study on addition of the second accessory ingredient ($Ta_2O_5$) (first accessory ingredient: Fe):

Samples of Examples 4-24 to 4-29 were produced, with $Ta_2O_5$ added as a second accessory ingredient and the amount thereof varied as shown in Table 27 below. The production method of the piezoelectric ceramic composition was the same as that in Experiment 4-1. The electrical resistance IR (relative value) at high temperatures and electromechanical coupling factor kr of each sample of these examples were measured in the same manner as in Experiment 4-1. The results thereof are shown in Table 27 below.

Table 27

| | Accessory ingredient composition | | Electrical resistance IR (relative value) | Electromechanical coupling factor kr (%) |
|---|---|---|---|---|
| | Fe content in terms of FeO (mass%) | $Ta_2O_5$ content (mass%) | | |
| Ex.4-24 | 0.05 | 0.0 | 36.6 | 66.2 |
| Ex.4-25 | 0.05 | 0.1 | 46.0 | 67.7 |
| Ex.4-26 | 0.05 | 0.2 | 38.8 | 68.6 |
| Ex.4-27 | 0.05 | 0.4 | 31.7 | 67.1 |
| Ex. 4-28 | 0.05 | 0.6 | 24.5 | 65.1 |
| Ex.4-29 | 0.05 | 1.0 | 10.8 | 53.7 |

As is clear from Table 27 above, where $Ta_2O_5$ is added as the second accessory ingredient, the effect of the addition of FeO can also be obtained, the electrical resistance at high temperatures is greatly improved, and the electromechanical coupling factor kr is suppressed from being lowered. However, a large amount of $Ta_2O_5$ added shows a tendency for both the hot load life and the electromechanical coupling factor kr to go down slightly.

Experiment 4-7: Study on the kind of the second accessory ingredient (first accessory ingredient: Fe):

Samples of Examples 4-30 to 4-34 were produced, with the oxides shown in Table 28 below added in the respective amounts shown in Table 28 below. The production method of the piezoelectric ceramic composition is the same as that in Experiment 4-1. The electrical resistance IR (relative value) at high temperatures and electromechanical coupling factor kr of each sample of these examples were measured in the same manner as in Experiment 4-1. The results thereof are shown in Table 28 below.

Table 28

| | First accessory ingredient | | Second accessory ingredient | | Electrical resistance IR (relative value) | Electromechanical coupling factor kr (%) |
|---|---|---|---|---|---|---|
| | Kind | Content (mass%) | Kind | Content (mass%) | | |
| Ex.4-30 | FeO | 0.05 | $Sb_2O_3$ | 0.3 | 5.4 | 70.6 |
| Ex.4-31 | FeO | 0.05 | $Nb_2O_5$ | 0.1 | 35.8 | 73.6 |

(continued)

| | First accessory ingredient | | Second accessory ingredient | | Electrical resistance IR (relative value) | Electromechanical coupling factor kr (%) |
|---|---|---|---|---|---|---|
| | Kind | Content (mass%) | Kind | Content (mass%) | | |
| Ex.4-32 | FeO | 0.05 | $WO_3$ | 0.05 | 8.3 | 69.7 |
| Ex.4-33 | FeO | 0.05 | $WO_3$ | 0.1 | 12.0 | 69.6 |
| Ex.4-34 | FeO | 0.05 | $WO_3$ | 0.5 | 8.6 | 68.6 |

It is clearly found from Table 28 above that any of the additives added in any of the amounts is effective, that the electrical resistance at high temperatures is high and that the electromechanical coupling factor kr is large.

Experiment 5-1: Experiment for confirming the effect of the addition of the first accessory ingredient (NiO) to a chief ingredient of $(Pb_{0.995-0.03}Sr_{0.03})$ $[(Zn_{1/3}Nb_{2/3})_{0.1}Ti_{0.43}Zr_{0.47}]O_3$:

Samples of Examples 5-1 to 5-6 and Comparative Examples 5-1 and 5-2 were produced, with Ni added to the chief ingredient so that the Ni content might be as shown in Table 29 below in terms of NiO. The production method of the piezoelectric ceramic composition in this experiment was the same as that in Experiment 1-1, and NiO was used as the material for the first accessory ingredient. The electrical resistance IR (relative value) at high temperatures and electromechanical coupling factor kr of each sample of these examples were measured. The results thereof are shown in Table 29 below.

Table 29

| | Ni content in terms of NiO (mass%) | Electrical resistance IR (relative value) | Electromechanical coupling factor kr (%) |
|---|---|---|---|
| Ex. 5-1 | 0.005 | 1.1 | 68.6 |
| Ex. 5-2 | 0.01 | 2.0 | 66.7 |
| Ex. 5-3 | 0.03 | 9.3 | 66.7 |
| Ex.5-4 | 0.05 | 29.5 | 69.7 |
| Ex. 5-5 | 0.1 | 22.7 | 64.1 |
| Ex. 5-6 | 0.2 | 5.6 | 60.0 |
| Comp. Ex. 5-1 | 0 | 1.0 | 68.9 |
| Comp. Ex.5-2 | 0.3 | 1.0 | 57.2 |

It is clearly found from Table 29 above that the addition of NiO that is the first accessory ingredient enables the electrical resistance at high temperatures to be greatly improved in comparison with the sample of Comparative Example 5-1 having no first accessory ingredient added thereto. When the content of NiO is unduly large as in the sample of Comparative Example 5-2, however, the degree of improvement in the electrical resistance IR at high temperatures is greatly lowered. Therefore, it can be said that preferably the NiO is added so that the content thereof may be 0.2 mass% or less.

Experiment 5-2: Study on the composition "a" of the element at the A-site in a chief ingredient of $(Pb_{a-0.03}Sr_{0.03})[(Zn_{1/3}Nb_{2/3})_{0.1}Ti_{0.43}Zr_{0.47}]O_3$ (first accessory ingredient: Ni):

Samples of Examples 5-7 to 5-10 were produced, with the composition "a" in the chief ingredient varied. The production method of the piezoelectric ceramic composition in this experiment was the same as that in Experiment 5-1. The electrical resistance IR (relative value) and electromechanical coupling factor kr of each sample of these examples were measured in the same manner as in Experiment 5-1. The results thereof are shown in Table 30 below.

**Table 30**

|  | Composition "a" in chief ingredient | Ni content in terms of NiO (mass%) | Electrical resistance IR (relative value) | Electromechanical coupling factor kr (%) |
|---|---|---|---|---|
| Ex. 5-7 | 0.96 | 0.05 | 3.4 | 60.5 |
| Ex.5-8 | 0.995 | 0.05 | 29.5 | 69.7 |
| Ex.5-9 | 1.005 | 0.05 | 31.7 | 67.3 |
| Ex. 5-10 | 1.03 | 0.05 | 20.3 | 61.6 |

As is clear from Table 30 above, the effect of the addition of NiO can also be obtained when the composition "a" is varied within the range prescribed in the present invention. In any of the samples, the electrical resistance at high temperatures is greatly improved, and the electromechanical coupling factor kr is suppressed from being lowered.

Experiment 5-3: Study on the composition "b" of the element at the A-site in a chief ingredient of $(Pb_{0.995-b}Sr_b)[(Zn_{1/3}Nb_{2/3})_{0.1}Ti_{0.43}Zr_{0.47}]O_3$ (first accessory ingredient: Ni):

Samples of Examples 5-11 to 5-15 were produced, with the composition "b" in the chief ingredient varied. The production method of the piezoelectric ceramic composition in this experiment was the same as that in Experiment 5-1. The electrical resistance IR (relative value) and electromechanical coupling factor kr of each sample of these examples were measured in the same manner as in Experiment 5-1. The results thereof are shown in Table 31 below.

Table 31

|  | Composition "b" in chief ingredient | Ni content in terms of NiO (mass%) | Electrical resistance IR (relative value) | Electromechanical coupling factor kr (%) |
|---|---|---|---|---|
| Ex. 5-11 | 0 | 0.05 | 31.3 | 60.8 |
| Ex.5-12 | 0.01 | 0.05 | 31.0 | 69.5 |
| Ex. 5-13 | 0.03 | 0.05 | 29.5 | 69.7 |
| Ex. 5-14 | 0.06 | 0.05 | 27.7 | 68.6 |
| Ex. 5-15 | 0.1 | 0.05 | 21.0 | 63.1 |

As is clear from Table 31 above, the effect of the addition of NiO can also be obtained when the composition "b" is varied within the range prescribed in the present invention. In any of the samples, the electrical resistance at high temperatures is greatly improved, and the electromechanical coupling factor kr is suppressed from being lowered.

Experiment 5-4: Study on substituted element Me at the A-site in a chief ingredient of $(Pb_{0.995-0.03}Me_{0.03})[(Zn_{1/3}Nb_{2/3})_{0.1}Ti_{0.43}Zr_{0.47}]O_3$ (first accessory ingredient: Ni):

Samples of Examples 5-16 and 5-17 were produced in the same manner as in Experiment 5-1, with the substituted element Me at the A-site in the chief ingredient changed to Ca or Ba. The results of measurements of the electrical resistance IR (relative value) at high temperatures and the electromechanical coupling factor kr are shown in Table 32 below.

Table 32

|  | Composition Me in chief ingredient | Ni content in terms of NiO (mass%) | Electrical resistance IR (relative value) | Electromechanical coupling factor kr (%) |
|---|---|---|---|---|
| Ex. 5-16 | Ca | 0.05 | 31.9 | 66.5 |
| Ex.5-17 | Ba | 0.05 | 25.1 | 69.0 |

As is clear from Table 32 above, the effect of the addition of NiO can also be obtained when the substituted element Me at the A-site in the chief ingredient changed from Sr to Ca or Ba. The electrical resistance at high temperatures is greatly improved, and the electromechanical coupling factor kr is suppressed from being lowered.

Experiment 5-5: Study on the compositions x, y and z of the elements at the B-site in a chief ingredient of $(Pb_{a-0.03}Sr_{0.03})$ $[(Zn_{1/3}Nb_{2/3})_xTi_yZr_z]O_3$ (first accessory ingredient: Ni):

Samples of Examples 5-18 to 5-23 and Comparative Experiment 5-2 were produced, with the compositions x, y and z of the elements at the B-site in the chief ingredient varied as shown in Table 33 below. The production method of the piezoelectric ceramic composition in this experiment was the same as that in Experiment 5-1. The electrical resistance IR (relative value) at high temperatures and electromechanical coupling factor kr of each sample of these examples were measured in the same manner as in Experiment 5-1. The results thereof are shown in Table 33 below.

Table 33

| | Compositions in chief ingredient | | | Ni content in terms of NiO (mass%) | Electrical resistance IR (relative value) | Electromechanical coupling factor kr (%) |
|---|---|---|---|---|---|---|
| | x | y | z | | | |
| Comp. Ex. 5-2 | 0.00 | 0.48 | 0.52 | 0.05 | 26.2 | 35.5 |
| Ex. 5-18 | 0.05 | 0.43 | 0.52 | 0.05 | 30.5 | 69.6 |
| Ex. 5-19 | 0.05 | 0.50 | 0.45 | 0.05 | 2.4 | 67.4 |
| Ex. 5-20 | 0.10 | 0.43 | 0.47 | 0.05 | 29.5 | 69.7 |
| Ex.5-21 | 0.10 | 0.45 | 0.45 | 0.05 | 17.8 | 66.3 |
| Ex.5-22 | 0.10 | 0.50 | 0.40 | 0.05 | 11.5 | 63.8 |
| Ex. 5-23 | 0.15 | 0.45 | 0.40 | 0.05 | 30.3 | 65.8 |

It is clearly found from Table 33 above that the effect of the addition of NiO can also be obtained when the compositions x, y and z of the elements at the B-site are varied, that the electrical resistance at high temperatures is greatly improved and that the electromechanical coupling factor kr is suppressed from being lowered. In Comparative Example 5-2 in which the compositions x, y and z of the elements at the B-site fall outside the ranges prescribed in the present invention, however, the electromechanical coupling factor kr is small, i.e. below the standard value (50%).

Experiment 5-6: Study on addition of the second accessory ingredient $(Ta_2O_5)$ (first accessory ingredient: Ni):

Samples of Examples 5-24 to 5-29 were produced, with $Ta_2O_5$ added as a second accessory ingredient and the amount thereof varied as shown in Table 34 below. The production method of the piezoelectric ceramic composition was the same as that in Experiment 5-1. The electrical resistance IR (relative value) at high temperatures and electromechanical coupling factor kr of each sample of these examples were measured in the same manner as in Experiment 5-1. The results thereof are shown in Table 34 below.

Table 34

| | Accessory ingredient composition | | Electrical resistance IR (relative value) | Electromechanical coupling factor kr (%) |
|---|---|---|---|---|
| | Ni content in terms of NiO (mass%) | $Ta_2O_5$ content (mass%) | | |
| Ex.5-24 | 0.05 | 0.0 | 27.7 | 67.2 |
| Ex.5-25 | 0.05 | 0.1 | 34.9 | 68.8 |
| Ex. 5-26 | 0.05 | 0.2 | 29.5 | 69.7 |
| Ex.5-27 | 0.05 | 0.4 | 24.0 | 68.1 |
| Ex.5-28 | 0.05 | 0.6 | 18.6 | 66.1 |
| Ex.5-29 | 0.05 | 1.0 | 8.2 | 54.5 |

As is clear from Table 34 above, where $Ta_2O_5$ is added as the second accessory ingredient, the effect of the addition of NiO can also be obtained, the electrical resistance at high temperatures is greatly improved, and the electromechanical coupling factor kr is suppressed from being lowered. However, a large amount of $Ta_2O_5$ added shows a tendency for both the hot load life and the electromechanical coupling factor kr to go down slightly.

Experiment 5-7: Study on the kind of the second accessory ingredient (first accessory ingredient: Ni):

Samples of Examples 5-30 to 5-34 were produced, with the oxides shown in Table 35 below added in the respective amounts shown in Table 35 below. The production method of the piezoelectric ceramic composition is the same as that in Experiment 5-1. The electrical resistance IR (relative value) at high temperatures and electromechanical coupling factor kr of each sample of these examples were measured in the same manner as in Experiment 5-1. The results thereof are shown in Table 35 below.

Table 35

| | First accessory ingredient | | Second accessory ingredient | | Electrical resistance IR (relative value) | Electromechanical coupling factor kr (%) |
|---|---|---|---|---|---|---|
| | Kind | Content (mass%) | Kind | Content (mass%) | | |
| Ex. 5-30 | NiO | 0.05 | $Sb_2O_3$ | 0.3 | 4.1 | 71.7 |
| Ex.5-31 | NiO | 0.05 | $Nb_2O_5$ | 0.1 | 27.2 | 74.7 |
| Ex. 5-32 | NiO | 0.05 | $WO_3$ | 0.05 | 6.3 | 70.8 |
| Ex.5-33 | NiO | 0.05 | $WO_3$ | 0.1 | 9.1 | 70.7 |
| Ex.5-34 | NiO | 0.05 | $WO_3$ | 0.5 | 6.5 | 69.7 |

It is clearly found from Table 35 above that any of the additives added in any of the amounts is effective, that the electrical resistance at high temperatures is high and that the electromechanical coupling factor kr is large.

Experiment 6: Confirmation of the effect of annealing treatment:

Each sample of Examples 1-1 to 1-6, 2-1 to 2-5, 3-1 to 3-6, 4-1 to 4-6, 5-1 to 5-6 and Comparative Examples 1-1, 2-1, 3-1, 4-1 and 5-1 was subjected to annealing treatment, after the calcination, at a temperature of 700°C under an oxygen partial pressure of 2 x 10$^{-5}$ atm and for two hours. The electrical resistance IR (relative value) of each sample after the annealing treatment is shown in Tables 36 to 40 below.

Table 36

| | Mn content in terms of MnO (mass%) | Electrical resistance IR (relative value) |
|---|---|---|
| Ex. 1-1 | 0.005 | 4.1 |
| Ex. 1-2 | 0.01 | 8.3 |
| Ex. 1-3 | 0.03 | 108.5 |
| Ex. 1-4 | 0.05 | 89.4 |
| Ex. 1-5 | 0.1 | 89.0 |
| Ex. 1-6 | 0.2 | 34.6 |
| Comp. Ex. 1-1 | 0 | 1.0 |

Table 37

| | Co content in terms of CoO (mass%) | Electrical resistance IR (relative value) |
|---|---|---|
| Ex. 2-1 | 0.005 | 3.3 |
| Ex. 2-2 | 0.01 | 6.6 |
| Ex. 2-3 | 0.05 | 78.3 |
| Ex. 2-4 | 0.1 | 22.1 |
| Ex. 2-5 | 0.2 | 2.3 |
| Comp. Ex. 2-1 | 0 | 1.1 |

Table 38

| | Cr content in terms of CrO (mass%) | Electrical resistance IR (relative value) |
|---|---|---|
| Ex. 3-1 | 0.005 | 1.1 |
| Ex. 3-2 | 0.01 | 1.9 |
| Ex. 3-3 | 0.03 | 6.8 |
| Ex. 3-4 | 0.05 | 7.6 |
| Ex. 3-5 | 0.1 | 6.6 |
| Ex. 3-6 | 0.2 | 1.4 |
| Comp. Ex. 3-1 | 0 | 1.0 |

Table 39

| | Cr content in terms of CrO (mass%) | Electrical resistance IR (relative value) |
|---|---|---|
| Ex. 4-1 | 0.005 | 3.3 |
| Ex. 4-2 | 0.01 | 6.5 |
| Ex. 4-3 | 0.03 | 4.4 |
| Ex. 4-4 | 0.05 | 4.8 |
| Ex. 4-5 | 0.1 | 3.8 |
| Ex. 4-6 | 0.2 | 1.9 |
| Comp. Ex. 4-1 | 0 | 1.0 |

Table 40

| | Ni content in terms of NiO (mass%) | Electrical resistance IR (relative value) |
|---|---|---|
| Ex. 5-1 | 0.005 | 28.8 |
| Ex. 5-2 | 0.01 | 57.5 |
| Ex. 5-3 | 0.03 | 53.0 |
| Ex. 5-4 | 0.05 | 35.1 |
| Ex. 5-5 | 0.1 | 30.1 |
| Ex. 5-6 | 0.2 | 2.2 |
| Comp. Ex. 5-1 | 0 | 1.0 |

As is clear from these tables, the particularly conspicuous effect of improvement in the electrical resistance IR can be confirmed when Mn, Co and Ni have been used as the first accessory ingredients. With respect to the electromechanical coupling factor kr, the values are hardly changed at all irrespective of undergoing or not undergoing the annealing treatment.

Experiment 7: Experiment for confirming the effect of addition of the first accessory ingredient [$CuO_x$ ($x \geq 0$)] to the chief ingredient of ($Pb_{0.995-0.03}Sr_{0.03}$) [($Zn_{1/3}Nb_{2/3})_{0.1}Ti_{0.43}Zr_{0.47}]O_3$:

A piezoelectric ceramic composition was produced by the following procedure. First, as raw materials for a chief ingredient, PbO powder, $SrCO_3$ powder, ZnO powder, $Nb_2O_5$ powder, $TiO_2$ powder and $ZrO_2$ powder were prepared and weighed out so that the chief ingredient had the aforementioned composition. These raw materials were wet-mixed with a ball mill for 16 hours and calcined in the air at a temperature in the range of 700°C to 900°C for two hours.

The calcined body thus obtained was pulverized, then added with a raw material for $CuO_x$ ($x \geq 0$) (additive

species: CuO) and wet-pulverized with a ball mill for 16 hours. The wet-pulverized grains were dried, added with acrylic resin as a binder, pelletized and molded under a pressure of around 445 MPa using a uniaxial press molding machine into a disc 17 mm in diameter and 1 mm in thickness. The disc was heat-treated to volatilize the binder and fired in a hypoxic reducing atmosphere (of an oxygen partial pressure in the range of $1 \times 10^{-10}$ to $1 \times 10^{-6}$ atm.) at 950°C for a period in the range of two to eight hours. The sintered body thus obtained was subjected to a slicing process and a lapping process into discs each having a thickness of 0.6 mm. Each disc was printed on the opposite surfaces with silver paste, seized at 350°C and applied with an electric field of 3 kV in silicone oil heated to 120°C, thereby undergoing a poling process.

In accordance with the above method, samples of Examples 7-1 to 7-7 and Comparative Examples 7-1 and 7-2 were produced, with the content of a raw material for $CuO_x$ ($x \geq 0$) (additive species: CuO) to be added varied to those shown in Table 41 below.

The sample of each example and comparative example was tested for the hot load life and measured in respect of the electromechanical coupling factor kr. The hot load life test comprises applying a voltage of 2 kV to five samples so that the field intensity at a temperature of 250°C may be 8 kV/mm and measuring the variation per hour in the insulation resistance thereof. Here, however, the time the insulation resistance of each sample was lowered by one order or more, with the value thereof immediately after the start of the test as the standard, was measured as the lifetime and the average lifetime measured is defined as the hot load life. The electromechanical coupling factor kr was also measured with an impedance analyzer (produced by Hewlett-Packard Co. under the product code of HP4194A). The results thereof are shown in Table 41 below.

Table 41

| | $CuO_x$ content in terms of CuO (mass%) | Addition time | Hot load life (min) | Electromechanical coupling factor kr (%) |
|---|---|---|---|---|
| Ex. 7-1 | 0.005 | After | 6.20E+03 | 66.5 |
| Ex.7-2 | 0.010 | After | 6.90E+03 | 66.5 |
| Ex.7-3 | 0.050 | After | 4.00E+04 | 66.6 |
| Ex.7-4 | 0.100 | After | 3.60E+04 | 66.1 |
| Ex.7-5 | 1.000 | After | 1.40E+04 | 64.6 |
| Ex.7-6 | 1.500 | After | 1.00E+04 | 63.9 |
| Ex. 7-7 | 3.000 | After | 8.40E+04 | 60.4 |
| Comp. Ex. 7-1 | 0.000 | - | 0.00E+00 | 66.5 |
| Comp. Ex. 7-2 | 5.000 | After | 6.60E+03 | 46.9 |

It is clearly found from Table 41 above that the addition of $CuO_x$ ($x \geq 0$) that is the first accessory ingredient enables the hot load life to be greatly improved in comparison with Comparative Example 7-1 added with no $CuO_x$ ($x \geq 0$). When the content of $CuO_x$ ($x \geq 0$) is unduly large as in Comparative Example 7-2, however, the electromechanical coupling factor kr is remarkably lowered while the hot load life is improved, and the value of the electromechanical coupling factor kr dips from 50% that is the standard value. Therefore, it can be said that preferably the content of $CuO_x$ ($x \geq 0$) is 3.0 mass% or less.

Experiment 8: Study on the raw material for the first accessory ingredient (additive species) and on the time of the addition thereof:

Cu, $Cu_2O$ and CuO were used as the additive species of the first accessory ingredient, and the difference in effect based on the difference in additive species was examined. The addition time of the additive species was set before or after the calcination, and the difference by the addition time was examined. Incidentally, "before" the calcination means the time the additive species was added when the raw materials for the chief ingredient were prepared, and thereafter the calcination and actual calcination were performed. Also, "after" the calcination means the time the additive species was added when the calcined body was pulverized in the same manner as in previous Experiment 7.

Samples 8-1 to 8-6 were produced in the same manner as Experiment 7, with the additive species and addition time varied as shown in Table 42. The hot load life and electromechanical coupling factor kr of each sample were measured in the same manner as mentioned above. The results thereof are shown in Table 42 below.

Table 42

| | Additive species | CuO$_x$ content in terms of CuO (mass%) | Addition time | Hot load life (min) | Electromechanical coupling factor kr (%) |
|---|---|---|---|---|---|
| Ex.8-1 | Cu | 0.05 | Before | 2.80E+04 | 73.7 |
| Ex.8-2 | Cu$_2$O | 0.05 | Before | 5.20E+04 | 69.2 |
| Ex. 8-3 | CuO | 0.05 | Before | 4.20E+04 | 70.6 |
| Ex.8-4 | Cu | 0.05 | After | 1.40E+04 | 69.5 |
| Ex. 8-5 | Cu$_2$O | 0.05 | After | 2.80E+04 | 67.9 |
| Ex.8-6 | CuO | 0.05 | After | 4.00E+04 | 66.6 |

As is clear from Table 42 above, the long lifetime can be obtained and the electromechanical coupling factor kr is suppressed from being lowered in any of the examples irrespective of the changes in additive species and addition time.

Experiment 9: Study on the composition "a" of the element at the A-site in a chief ingredient of $(Pb_{a \cdot 0.03}Sr_{0.03})[(Zn_{1/3}Nb_{2/3})_{0.1}Ti_{0.43}Zr_{0.47}]O_3$:

Samples of Examples 9-1 to 9-4 were produced, with the composition "a" in the chief ingredient varied. The production method of the piezoelectric ceramic component was the same as that of Experiment 7. The hot load life and electromechanical coupling factor kr of each sample were measured in the same manner as in Experiment 7 or 8. The results thereof are shown in Table 43 below.

Table 43

| | Composition "a" in chief ingredient | Cu content in terms of CuO (mass%) | Addition time | Hot load life (min) | Electromechanical coupling factor kr (%) |
|---|---|---|---|---|---|
| Ex. 9-1 | 0.960 | 0.05 | After | 4.60E+03 | 57.8 |
| Ex. 9-2 | 0.995 | 0.05 | After | 4.00E+04 | 66.6 |
| Ex. 9-3 | 1.005 | 0.05 | After | 4.30E+04 | 64.4 |
| Ex. 9-4 | 1.030 | 0.05 | After | 2.80E+04 | 58.9 |

Experiment 10: Study on the composition "b" of the element at the A-site in a chief ingredient of $(Pb_{0.995-b}Sr_b)[(Zn_{1/3}Nb_{2/3})_{0.1}Ti_{0.43}Zr_{0.47}]O_3$:

Samples of Examples 10-1 to 10-5 were produced, with the composition "b" varied. The production method of the piezoelectric ceramic composition was the same as that in Experiment 7. The hot load life and electromechanical coupling factor kr of each sample were measured in the same manner as in Experiments 7 to 9. The results thereof are shown in Table 44 below.

Table 44

| | Composition "b" in chief ingredient | Cu content in terms of CuO (mass%) | Addition time | Hot load life (min) | Electromechanical coupling factor kr (%) |
|---|---|---|---|---|---|
| Ex. 10-1 | 0.00 | 0.05 | After | 4.30E+04 | 58.1 |
| Ex. 10-2 | 0.01 | 0.05 | After | 4.30E+04 | 66.4 |
| Ex. 10-3 | 0.03 | 0.05 | After | 4.00E+04 | 66.6 |
| Ex. 10-4 | 0.06 | 0.05 | After | 3.80E+04 | 65.5 |
| Ex. 10-5 | 0.10 | 0.05 | After | 2.90E+04 | 60.3 |

As is clear from Table 44 above, the effect of the addition of $CuO_x$ ($x \geq 0$) can also be obtained when the composition "b" is varied within the range prescribed in the present invention. In any of the examples, the hot load life is greatly improved, and the electromechanical coupling factor kr is suppressed from being lowered.

Experiment 11: Study on substituted Me at the A-site in a chief ingredient of $(Pb_{0.995-0.03}Sr_{0.03})[(Zn_{1/3}Nb_{2/3})_{0.1}Ti_{0.43}Zr_{0.47}]O_3$:

Samples of Examples 11-1 and 11-2 were produced in the same manner as in Example 7, with the substituted Me at the A-site in the chief ingredient changed to Ca or Ba. The hot load life and electromechanical coupling factor kr of each sample are shown in Table 45 below.

Table 45

|  | Composition Me in chief ingredient | $CuO_x$ content in terms of CuO (mass%) | Hot load life (sec) | Electromechanical coupling factor kr (%) |
|---|---|---|---|---|
| Ex. 11-1 | Ca | 0.05 | 4.40E+04 | 62.4 |
| Ex. 11-2 | Ba | 0.05 | 3.40E+04 | 64.2 |

As is clear from Table 45 above, the effect of the addition of $CuO_x$ ($x \geq 0$) can also be obtained when the substituted element at the A-site in the chief ingredient is changed from Sr to Ca or Ba, the hot load life is greatly improved, and the electromechanical coupling factor kr is suppressed from being lowered.

Experiment 12: Study on the compositions x, y and z at the B-site in a chief ingredient of $(Pb_{a-0.03}Sr_{0.03})[(Zn_{1/3}Nb_{2/3})_{0.1}Ti_{0.43}Zr_{0.47}]O_3$:

Samples of Examples 12-1 to 12-6 and Comparative Example 12-1 were produced, with the compositions x, y and z of the elements at the B-site in the chief ingredient varied as shown in Table 46 below. The production method of the piezoelectric ceramic composition was the same as in Example 7. The hot load life and electromechanical coupling factor kr of each sample were measured in the same manner as in Example 7. The results thereof are shown in Table 46 below.

Table 46

|  | Compositions in chief ingredient | | | CuOx content in terms of CuO (mass%) | Hot load life (sec) | Electromechanical coupling factor kr (%) |
|---|---|---|---|---|---|---|
|  | x | y | z |  |  |  |
| Comp. Ex.12-1 | 0.00 | 0.48 | 0.52 | 0.05 | 3.60E+04 | 34.0 |
| Ex.12-1 | 0.05 | 0.43 | 0.52 | 0.05 | 4.20E+04 | 66.5 |
| Ex.12-2 | 0.05 | 0.50 | 0.45 | 0.05 | 3.30E+03 | 64.5 |
| Ex. 12-3 | 0.10 | 0.43 | 0.47 | 0.05 | 4.00E+04 | 66.6 |
| Ex. 12-4 | 0.10 | 0.45 | 0.45 | 0.05 | 2.40E+04 | 63.4 |
| Ex.12-5 | 0.10 | 0.50 | 0.40 | 0.05 | 1.60E+04 | 61.0 |
| Ex.12-6 | 0.15 | 0.45 | 0.40 | 0.05 | 4.20E+04 | 62.9 |

It is clearly found Table 46 above that the effect of the addition of $CuO_x$ ($x \geq 0$) can also be obtained when the compositions x, y and z of the elements at the B-site in the chief ingredient are varied, that the hot load life is greatly improved and that the electromechanical coupling factor kr is suppressed from being lowered. In Comparative Example 12-1 in which the compositions x, y and z of the elements at the B-site fall outside the ranges prescribed in the present invention, however, the electromechanical coupling factor kr is small, i.e. below the standard value (50%).

Experiment 13: Study on addition of the second accessory ingredient ($Ta_2O_5$):

Samples of Examples 13-1 to 13-6 were produced, with $Ta_2O_5$ added as the second accessory ingredient and the content thereof varied as shown in Table 47 below. The production method of the piezoelectric ceramic composition was the same as in Example 7. The hot load life and electromechanical coupling factor kr of each sample were measured in the same manner as in Example 7. The results thereof are shown in Table 47 below.

Table 47

| | Accessory ingredient composition | | Hot load life (min) | Electromechanical coupling factor kr (%) |
|---|---|---|---|---|
| | $CuO_x$ content (mass%) | $Ta_2O_5$ content (mass%) | | |
| Ex. 13-1 | 0.05 | 0.0 | 3.80E+04 | 64.3. |
| Ex. 13-2 | 0.05 | 0.1 | 4.80E+04 | 65.7 |
| Ex. 13-3 | 0.05 | 0.2 | 4.00E+04 | 66.6 |
| Ex. 13-4 | 0.05 | 0.4 | 3.30E+04 | 65.1 |
| Ex. 13-5 | 0.05 | 0.6 | 2.60E+04 | 63.2 |
| Ex. 13-6 | 0.05 | 1.0 | 1.10E+04 | 52.1 |

As is clear from Table 47 above, where $Ta_2O_5$ is added as the second accessory ingredient, the effect of the addition of $CuO_x$ ($x \geq 0$) can also be obtained, the hot load life is greatly improved, and the electromechanical coupling factor kr is suppressed from being lowered. However, a large amount of $Ta_2O_5$ added shows a tendency for both the hot load life and the electromechanical coupling factor kr to go down slightly.

Experiment 14: Study on the kind of the second accessory ingredient:

Samples of Examples 14-1 to 14-5 were produced, with the oxides shown in Table 48 below added in the amounts shown in Table 48 below. The production method of the piezoelectric ceramic composition was the same as in Example 7. The hot load life and electromechanical coupling factor kr of each sample were measured in the same manner as in Example 7. The results thereof are shown in Table 48 below.

Table 48

| | First accessory ingredient | | Second accessory ingredient | | Hot load life (sec) | Electromechanical coupling factor kr (%) |
|---|---|---|---|---|---|---|
| | Kind | Content (mass%) | Kind | Content (mass%) | | |
| Ex. 14-1 | $CuO_x$ | 0.05 | $Sb_2O_3$ | 0.30 | 2.80E+03 | 68.5 |
| Ex. 14-2 | $CuO_x$ | 0.05 | $Nb_2O_5$ | 0.10 | 1.90E+04 | 71.4 |
| Ex. 14-3 | $CuO_x$ | 0.05 | $WO_3$ | 0.05 | 4.30E+03 | 67.6 |
| Ex. 14-4 | $CuO_x$ | 0.05 | $WO_3$ | 0.10 | 6.30E+03 | 67.5 |
| Ex. 14-5 | $CuO_x$ | 0.05 | $WO_3$ | 0.50 | 4.50E+03 | 66.6 |

It is clearly found that the effect of the addition can be obtained in any of the additive in any of the amounts, that the hot load life is long and that the electromechanical coupling factor kr is large.

Experiment 15-1: Experiment for confirming the effect of diffusion of Cu:

A piezoelectric ceramic composition was produced by the following procedure. First, as raw materials for a chief ingredient of $(Pb_{0.995-0.03}Sr_{0.03})$ $[(Zn_{1/3}Nb_{2/3})_{0.1}Ti_{0.43}Zr_{0.47}]O_3$, PbO powder, $SrCO_3$ powder, ZnO powder, $Nb_2O_5$ powder, $TiO_2$ powder and $ZrO_2$ powder were prepared and weighed out so that the chief ingredient had the aforementioned composition. These raw materials were wet-mixed with a ball mill for 16 hours and calcined in the air at a temperature in the range of 700°C to 900°C for two hours.
The calcined body thus obtained was pulverized and then wet-pulverized with a ball mill for 16 hours. The wet-pulverized grains were dried, added with acrylic resin as a binder, pelletized and molded under a pressure of around 445 MPa using a uniaxial press molding machine into a disc 17 mm in diameter and 1 mm in thickness. The molded disk was printed on the opposite surfaces with Cu paste containing Cu powder having a grain size of 1.0 μm. The pellet thus obtained was heat-treated to volatilize the binder and fired in a hypoxic reducing atmosphere (of an oxygen partial pressure in the range of $1 \times 10^{-10}$ to $1 \times 10^{-6}$ atm.) at 950°C for eight hours. The sintered body thus obtained was subjected to a slicing process and a lapping process into discs each having a thickness of 0.6 mm. Each disc was deprived of the printed Cu paste and simultaneously processed into a shape capable of evaluation of its characteristics. The sample thus obtained was printed on the opposite surfaces with silver paste, seized at 350°C and applied with an electric field of 3 kV in silicone oil heated to 120°C, thereby undergoing a poling process.

A sample of Example 15-1 was produced in accordance with the method described above and, at the same time, a sample of Comparative Example 15-1 was produced without performing the printing of the Cu paste. The electrical resistance IR and electromechanical coupling factor kr of each sample of the example and comparative example were measured. The electromechanical coupling factor kr was measured with an impedance analyzer (produced by Hewlett-Packard Co. under the product code of HP4194A). The results thereof are shown in Table 49 below. It is noted that the electrical resistance IR (relative value) means the value obtained by dividing the resistance value of each sample at 150°C by the resistance value at 150°C in the case of no additive (Comparative Example 15-1).

Table 49

|  | Application of Cu paste | Grain size of Cu in Cu paste ($\mu$m) | Electrical resistance IR (relative value | Electromechanical coupling factor kr (%) |
|---|---|---|---|---|
| Ex. 15-1 | Yes | 1.0 | 124 | 66.1 |
| Comp. Ex. 15-1 | - | - | 1 | 66.5 |

It is found from Table 49 above that the electrical resistance of the sample of Example 15-1 printed with the Cu paste is greatly improved. Though the characteristic (electromechanical coupling factor kr) was slightly reduced, the reduction fell within the range capable of wearing. Therefore, the sample of Example 15-1 was subjected to ICP (Inductively Coupled Plasma) analysis. A sample for the ICP analysis was produced by adding 1 g of $Li_2B_2O_7$ to 0.1g of the sample and melting the mixture at 1050°C for 15 minutes. To the melt 0.2 g of $(COOH)_2$ and 110 m$\ell$ of HC were added, and the mixture was melted by heating to fix the volume of 100 m$\ell$. The measurement was performed using ICP-AES (Inductively Coupled Plasma Atomic Emission Spectroscopy (produced by Shimadzu Corporation under a product code of ICPS-8000). As a result, it was found that Cu was contained in an amount of 0.1 mass% in terms of CuO.

Experiment 15-2: Study on composition "a" of the element at the A-site in a chief ingredient of $(Pb_{a-0.03}Sr_{0.03})[(Zn_{1/3}Nb_{2/3})_{0.1}Ti_{0.43}Zr_{0.47}]O_3$:

Samples of Examples 15-2 to 15-5 were produced, with the composition "a" in a chief ingredient of $(Pb_{a-0.03}Sr_{0.03})[(Zn_{1/3}Nb_{2/3})_{0.1}Ti_{0.43}Zr_{0.47}]O_3$ varied. The production method of the piezoelectric ceramic composition is the same as that in Example 5-1. The electric resistance IR (relative value) and the electromechanical coupling coefficient kr of each sample were measured in the same manner as in Example 15-1. The results thereof are shown in Table 50 below.

Table 50

|  | Composition "a" in chief ingredient | Electrical resistance (relative value) | Electromechanical coupling factor kr (%) |
|---|---|---|---|
| Ex. 15-2 | 0.960 | 16 | 57.4 |
| Ex. 15-3 | 0.995 | 138 | 66.1 |
| Ex. 15-4 | 1.005 | 148 | 63.9 |
| Ex. 15-5 | 1.030 | 96 | 58.5 |

As is clear from Table 50 above, the effect of the diffusion of Cu can also be obtained when the composition "a" is varied within the range prescribed in the present invention and, in any of the examples, the electrical resistance at high temperatures is greatly improved.

Experiment 15-3: Study on the composition "b" of the element at the A-site in a chief ingredient of $(Pb_{0.995-b}Sr_b)[(Zn_{1/3}Nb_{2/3})_{0.1}Ti_{0.43}Zr_{0.47}]O_3$:

Samples of Examples 15-6 to 15-10 were produced, with the composition in the chief ingredient varied. The production method of the piezoelectric ceramic composition was the same as in Example 15-1. The electric resistance IR (relative value) and the electromechanical coupling coefficient kr of each sample were measured in the same manner as in Example 15-1 or 15-2. The results thereof are shown in Table 51 below.

Table 51

| | Composition "a" in chief ingredient | Electrical resistance IR (relative value) | Electromechanical coupling factor kr (%) |
|---|---|---|---|
| Ex. 15-6 | 0.00 | 148 | 57.7 |
| Ex.15-7 | 0.01 | 148 | 65.9 |
| Ex. 15-8 | 0.03 | 138 | 66.1 |
| Ex. 15-9 | 0.06 | 131 | 65.0 |
| Ex. 15-10 | 0.10 | 100 | 59.8 |

As is clear from Table 51 above, the effect of the diffusion of Cu can also be obtained when the composition "b" is varied within the range prescribed in the present invention and, in any of the examples, the electrical resistance at high temperatures is greatly improved.

Experiment 15-4: Study on the substituted element Me at the A-site in a chief ingredient of $(Pb_{0.995-0.03}Me_{0.03})[(Zn_{1/3}Nb_{2/3})_{0.1}Ti_{0.43}Zr_{0.47}]O_3$:

Samples of Examples 15-11 and 15-12 were produced in the same manner as in Example 15-1, with the substituted element Me changed to Ca or Ba. The results of the measurements of the electric resistance IR (relative value) at high temperatures and the electromechanical coupling coefficient kr of each are shown in Table 52 below.

Table 52

| | Composition Me in chief ingredient | Electrical resistance IR (relative value) | Electromechanical Coupling factor kr (%) |
|---|---|---|---|
| Ex.15-11 | Ca | 152 | 61.9 |
| Ex. 15-12 | Ba | 117 | 63.7 |

As is clear from Table 52 above, the effect of the diffusion of Cu is obtained when the substituted element Me at the A-site in the chief ingredient is changed from Sr to Ca or Ba, and the electrical resistance at high temperatures is greatly improved.

Experiment 15-5: Study on the compositions x, y and z of the elements at the B-site of a chief ingredient of $(Pb_{a-0.03}Sr_{0.03})[(Zn_{1/3}Nb_{2/3})_xTi_yZr_z]O_3$:

Samples of Examples 15-13 to 15-119 were produced, with the compositions x, y and z of the elements at the B-site in the chief ingredient varied as shown in Table 53 below. The production method of the piezoelectric ceramic composition is the same as in Example 15-1. The electrical resistance IR (relative value) at high temperatures and electromechanical coupling factor kr of each sample were measured in the same manner as in Example 15-1. The results thereof are shown in Table 53 below.

Table 53

| | Compositions in chief ingredient | | | Electrical resistance IR (relative value) | Electromechanical coupling factor kr (%) |
|---|---|---|---|---|---|
| | x | y | z | | |
| Ex. 15-13 | 0.00 | 0.48 | 0.52 | 124 | 33.7 |
| Ex. 15-14 | 0.05 | 0.43 | 0.52 | 145 | 66.0 |
| Ex.15-15 | 0.05 | 0.50 | 0.45 | 11 | 64.0 |
| Ex. 15-16 | 0.10 | 0.43 | 0.47 | 138 | 66.1 |

(continued)

| | Compositions in chief ingredient | | | Electrical resistance IR (relative value) | Electromechanical coupling factor kr (%) |
|---|---|---|---|---|---|
| | x | y | z | | |
| Ex. 15-17 | 0.10 | 0.45 | 0.45 | 83 | 62.9 |
| Ex. 15-18 | 0.10 | 0.50 | 0.40 | 55 | 60.5 |
| Ex. 15-19 | 0.15 | 0.45 | 0.40 | 145 | 62.4 |

It is clearly found from Table 53 above that the effect of the diffusion of Cu can also be obtained when the compositions x, y and z of the elements at the B-site are varied, that the electrical resistance at high temperatures is greatly improved and that the electromechanical coupling factor kr is suppressed from being lowered. In Example 15-3 in which the compositions x, y and z of the elements at the B-site fall outside the ranges prescribed in the present invention, however, the electromechanical coupling factor kr is small

Experiment 15-6: Study on the addition of the second accessory ingredient ($Ta_2O_5$):

Samples of Examples 15-20 to 15-25 were produced, with $Ta_2O_5$ added as the second accessory ingredient and the amount thereof varied as shown in Table 54 below. The production method of the piezoelectric ceramic composition was the same as in Example 15-1. The electrical resistance IR (relative value) at high temperatures and electromechanical coupling factor kr of each sample were measured in the same manner as in Example 15-1. The results thereof are shown in Table 54 below.

Table 54

| | $Ta_2O_5$ content (mass%) | Electrical resistance (relative value | Electromechanical coupling factor kr (%) |
|---|---|---|---|
| Ex.15-20 | 0.0 | 131 | 63.8 |
| Ex. 15-21 | 0.1 | 165 | 65.2 |
| Ex.15-22 | 0.2 | 138 | 66.1 |
| Ex.15-23 | 0.4 | 114 | 64.6 |
| Ex.15-24 | 0.6 | 90 | 62.7 |
| Ex. 15-25 | 1.0 | 38 | 51.7 |

As is clear from Table 54 above, where $Ta_2O_5$ is added as the second accessory ingredient, the effect of the diffusion of Cu can also be obtained, the electrical resistance at high temperatures is greatly improved, and the electromechanical coupling factor kr is suppressed from being lowered. However, a large amount of $Ta_2O_5$ added shows a tendency for both the hot load life and the electromechanical coupling factor kr to go down slightly.

Experiment 15-7: Study on the kinds of accessory ingredients:

Samples of Examples 15-26 to 15-30 were produced, with the oxides shown in Table 55 below added in the amounts shown in Table 55 below. The production method of the piezoelectric ceramic composition was the same as in Example 15-1. The electrical resistance IR (relative value) and electromechanical coupling factor kr of each sample were measured in the same manner as in Example 15-1. The results thereof are shown in Table 55 below.

Table 55

| | Second accessory ingredient | | Electrical Resistance IR (relative value) | Electromechanical coupling factor kr (%) |
|---|---|---|---|---|
| | Kind | Content (mass%) | | |
| Ex. 15-26 | $Sb_2O_3$ | 0.30 | 10 | 68.0. |
| Ex. 15-27 | $Nb_2O_5$ | 0.10 | 65 | 70.9 |
| Ex. 15-28 | $WO_3$ | 0.05 | 15 | 67.1 |

(continued)

| | Second accessory ingredient | | Electrical Resistance IR (relative value) | Electromechanical coupling factor kr (%) |
|---|---|---|---|---|
| | Kind | Content (mass%) | | |
| Ex. 15-29 | WO$_3$ | 0.10 | 22 | 67.0 |
| Ex. 15-30 | WO$_3$ | 0.50 | 16 | 66.1 |

It is clearly found that the effective of the addition of any additive in any amount can be obtained, that the electrical resistance at high temperatures is high and that the electromechanical coupling factor kr is large.

Experiment 16: Fabrication of multilayer piezoelectric element:

In the fabrication of a multilayer piezoelectric element, a vehicle was added to power of the piezoelectric ceramic composition produced by pulverizing the calcined body obtained in Example 15-1, and the resultant mixture was kneaded to produce paste for a piezoelectric layer. At the same time, Cu powder that was a conductive material and a vehicle were kneaded to produce paste for an internal electrode. Subsequently, a green chip that was a precursor of a multilayer body was produced by means of printing using the paste for the piezoelectric layer and paste for the internal electrode. The green chip was subjected to debinder treatment and to calcination under reducing and firing conditions, thereby obtaining a multilayer body. The reducing and firing conditions included the calcination in a reducing atmosphere (of 1 x 10$^{-10}$ to 1 x 10$^{-6}$ atm., for example) at a firing temperature in the range of 800°C to 1200°C.

The multilayer body (Example 16-1) was measured in respect of its cross section with EPMA (EPMA-1600). The electrical resistance IR (relative value) and electromechanical coupling factor kr of the multilayer body were measured in the same manner as in Example 15-1. The results thereof are shown in Table 56 below.

Table 56

| | Shape | grain size of Cu in Cu paste (μm) | Amount of additive ceramic powder in Cu paste (wt%) | Electrical resistance IR (relative value) |
|---|---|---|---|---|
| Ex. 16-1 | Multilayer | 0.2 | 5.0 | 112 |
| Comp. Ex. 15-1 | Bulk | - | - | 1 |

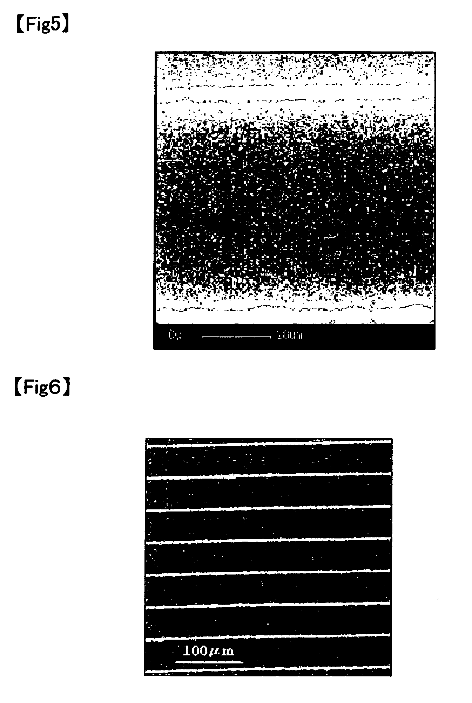

The piezoelectric layers per se constituting the multilayer body exhibit low electrical resistance at high temperatures. By firing the layers to produce the multilayer body, however, the electrode Cu was diffused in the piezoelectric layers to enable the electrical resistance at high temperature to be considerably improved. As a result of examining the state of existing Cu with the EPMA, as shown in FIG. 5, it was found that Cu existed uniformly without any segregation thereof.

Experiment 17: Study on control of amount of Cu diffused, by the grain size of Cu contained in Cu paste:

Samples of Examples 17-1 to 17-3 were produced in the same manner as in Example 15-1, with the grain size of Cu powder contained in Cu paste. Incidentally, in Examples 17-1 and 17-3, the Cu paste was added as additive powder with PZT powder (powder of a ceramic composition composed of lead titanate and lead zirconate) in order to heighten the strength of joint between the electrode layer and the piezoelectric layer and, in Example 17-2, the Cu paste was added with Ni powder. The amounts of the additive powder and Ni powder added are shown in Table 57 below. Each sample was subjected to measurement of the electrical resistance IR (relative value) at high temperatures and to ICP analysis in the same manner as in Example 15-1. The results thereof are shown in Table 57 below.

Table 57

| | Grain size of Cu in Cu paste (μm) | Amount of additive powder in Cu paste (wt%) | Amount of Ni powder in Cu paste (wt%) | Electrical Resistance IR (relative value) | Amount of Cu diffused (wt%) |
|---|---|---|---|---|---|
| Ex. 15-1 | 1.0 | 0.0 | - | 124 | 0.094 |
| Ex. 17-1 | 1.0 | 20 | - | 105 | 0.092 |

(continued)

|  | Grain size of Cu in Cu paste ($\mu$m) | Amount of additive powder in Cu paste (wt%) | Amount of Ni powder in Cu paste (wt%) | Electrical Resistance IR (relative value) | Amount of Cu diffused (wt%) |
|---|---|---|---|---|---|
| Ex. 17-2 | 1.0 | - | 20 | 99 | 0.100 |
| Ex.17-3 | 0.3 | 20 | - | 101 | 0.076 |

As a result, it was found that the change in grain size of Cu powder in Cu paste could change the amount of Cu diffused. To be specific, the smaller the Cu grain size, the smaller the diffusion amount. Since Cu when existing even in a small amount can improve the electrical resistance at high temperatures, it can be said that a smaller amount of Cu diffused is desirable in order not to deteriorate the characteristics.

Experiment 18: Addition of Cu as an ingredient for piezoelectric body layer:

A piezoelectric ceramic composition was produced in the following manner. As materials for a chief ingredient of $(Pb_{0.995-0.03}Sr_{0.03})[(Zn_{1/3}Nb_{2/3})_{0.1}Ti_{0.43}Zr_{0.47}]O_3$, PbO powder, $SrCO_3$ powder, ZnO powder, $Nb_2O_5$ powder, $TiO_2$ powder and $ZrO_2$ powder were prepared and weighed out to obtain the composition of the chief ingredient. These raw materials were then wet-mixed with a ball mill for 16 hours and calcined in the air at 700°C to 900°C.
The temporarily cancined body was pulverized and then added with the raw material (additive species: CuO) for $CuO_x$ ($x \geq 0$), and the resultant mixture was wet-pulverized with a ball mill for 16 hours. The wet-pulverized mixture was dried and added with a vehicle and kneaded to produce paste for the piezoelectric layer. At the same time, Cu powder that was a conductive material was kneaded with a vehicle to produce paste for the internal electrode. Subsequently, a green chip that was a precursor of the multilayer body was produced by the printing method using the paste for the piezoelectric layer and paste for the internal electrode. The green chip was subjected to debinder treatment and to calcination under the reducing and firing conditions to obtain a multilayer body. The reducing and firing conditions included the calcination in a reducing atmosphere (of $1 \times 10^{-10}$ to $1 \times 10^{-6}$ atm., for example) at a firing temperature in the range of 800°C to 1200°C.
The thus obtained multilayer body (Example 18-1) was measured with respect to the electrical resistance IR (relative value) and permittivity $\varepsilon$ in the same manner as in Example 15-1. The results thereof are shown in Table 58 below.

Table 58

|  | Shape | $CuO_x$ content in terms of CuO (mass%) | Electrical resistance IR (relative value) | Permittivity ($\varepsilon$) |
|---|---|---|---|---|
| Ex.18-1 | Multilayer | 0.1 | 112 | 1646 |
| Ex.15-1 | Bulk | 0.1 | 124 | 1995 |

The addition of Cu to the piezoelectric layer greatly improved the electrical resistance at high temperatures similarly in the case of the Cu diffusion. In addition, a decrease in permittivity $\varepsilon$ at that time was slight.

Experiment 19: Study on maldistribution of Cu:

A piezoelectric ceramic composition was produced in the following manner. As materials for a chief ingredient of $(Pb_{0.965}Sr_{0.03})[(Zn_{1/3}Nb_{2/3})_{0.1}Ti_{0.43}Zr_{0.47}]O_3$, PbO powder, $SrCO_3$ powder, ZnO powder, $Nb_2O_5$ powder, $TiO_2$ powder and $ZrO_2$ powder were prepared and weighed out to obtain the composition of the chief ingredient. These raw materials were then wet-mixed using a ball mill for 16 hours and calcined in the air at 700°C to 900°C.
The calcined body was pulverized and then wet-pulverized using a ball mill for 16 hours. The resultant grains were dried, added with a vehicle and kneaded to produce paste for the piezoelectric layer. At the same time, Cu powder that was a conductive material was kneaded with a vehicle to produce paste for the internal electrode. Subsequently, a green chip that was a precursor of a multilayer body was produced by the printing method using the paste for the piezoelectric layer and paste for the internal electrode. The green chip was subjected to debinder treatment and calcination under the reducing and firing conditions to obtain a multilayer body. The reducing and firing conditions included setting so that the oxygen partial pressure at the calcination-reaching temperature Ti (950°C) fell in the vicinity of an oxygen partial pressure under which metal copper and lead oxide might coexist an atmosphere gas to be introduced, introducing the atmosphere gas into a furnace, the temperature in which reached 1000°C. The inside of the furnace was stabilized for one hour and then the internal temperature elevation was started.

The piezoelectric body layer of the multilayer piezoelectric element thus fabricated was subjected to EPMA. FIG. 6 shows the analysis result by the EPMA. The EPMA revealed few segregations of Cu, and around two to three Cu granular segregations were found in the field of view of 900 $\mu$m x 900 $\mu$m.

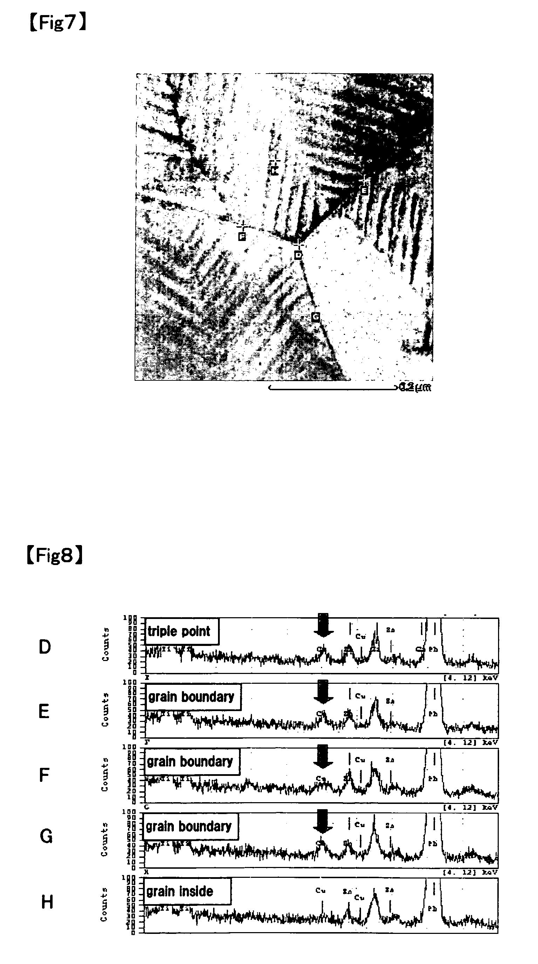

The region in which no Cu segregation was found by the EPMA was then analyzed with an FE-TEM. FIG. 7 is a TEM image of the piezoelectric body layer. The piezoelectric body layer is formed as an aggregate of the crystal grains in which grain boundaries extending in three directions, with a triple point shown by point D in the image as the center, are observed. The compositions of points D (triple point), E (grain boundary), F (grain boundary), G (grain boundary) and H (grain inside) were analyzed with a Transmission Electron Microscope-Energy Dispersive x-ray Spectroscopy (TEM-EDS). The results thereof are shown in FIG. 8. At points D (triple point), E (grain boundary), F (grain boundary) and G (grain boundary), the presence of Cu was confirmed. On the other hand, no Cu peak was confirmed at point H (grain inside).

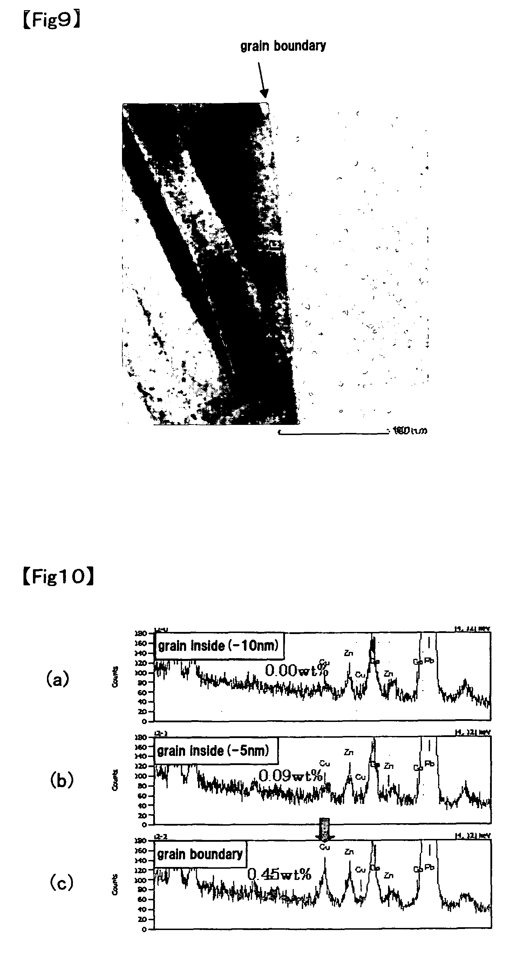

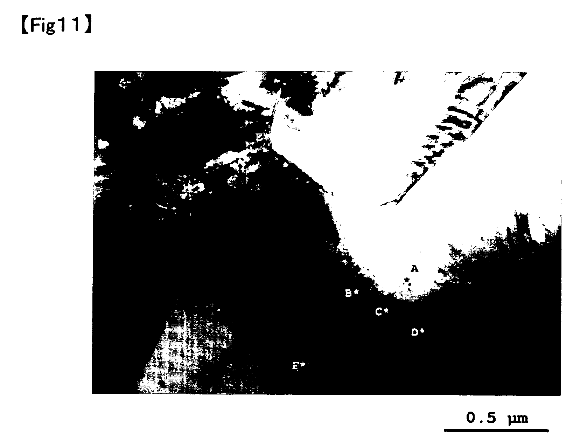

The neighborhood of the grain boundary was enlarged to examine the Cu distribution with an FE-TEM. FIG. 9 is an enlarged TEM image. The results of the analysis of the composition in the vicinity of the grain boundary with the TEM-EDS are shown in FIG. 10. FIG. 10(a) shows the composition analysis results at the grain inside (10 nm from the grain boundary), FIG. 10(b) those at the grain inside (5 nm from the grain boundary) and FIG. 10(c) those at the grain boundary. The Cu peak can clearly be observed at the grain boundary and, also at the position 5 nm apart from the grain boundary, the Cu peak can be observed, whereas it is difficult to observe a Cu peak at the position 10 nm apart from the grain boundary.

For comparison, a piezoelectric ceramic composition was produced, with CuO added. FIG. 11 is a TEM image of the piezoelectric ceramic composition thus obtained. As a result of the composition analysis, the presence of Cu was not found either at point C (grain boundary) or at point E (triple point). On the other hand, the crystal grain at point F was comprised of 3.7 mass% of PbO, 0.8 mass% of ZrO, 1.9 mass% of $Ta_2O_5$ and 93.6 mnass% of CuO. Thus, it was found that the major part of the crystal grain was comprised of CuO. Therefore, it was found that in the piezoelectric ceramic composition produced, with CuO added, the CuO was granularly segregated.

The multilayer piezoelectric element fabricated described above (presence of Cu maldistribution in the grain boundary) and a multiplayer piezoelectric element changed in conditions, with no Cu diffused (absence of Cu maldistribution in the grain boundary), were subjected to Highly Accelerated Life Test (HALT). As a result, the acceleration voltage load property of the multilayer piezoelectric element having no Cu maldistribution in the grain boundary (corresponding to Comparative Examples) was 0 sec, whereas that of the multi layer piezoelectric element having Cu maldistribution in the grain boundary (corresponding to Examples) was greatly improved to $2.0 \times 10^4$ sec.

## Claims

1. A piezoelectric ceramic composition comprising:

   as a chief ingredient a composite oxide that has Pb, Ti and Zr as constituent elements; and
   as a first accessory ingredient at least one element selected from the group consisting of Mn, Co, Cr, Fe and Ni in an amount of 0.2 mass% or less excluding 0 mass% in terms of an oxide.

2. A piezoelectric ceramic composition according to claim 1, wherein it is that fired under reducing and firing conditions.

3. A piezoelectric ceramic composition according to claim 2, wherein the reducing and firing conditions comprise a firing temperature in a range of 800°C to 1200°C and an oxygen partial pressure in a range of $1 \times 10^{-10}$ to $1 \times 10^{-6}$ atm.

4. A piezoelectric ceramic composition according to claim 1, wherein the composite oxide is at least one of $Pb_a[(Zn_{1/3}Nb_{2/3})_x Ti_y Zr_z]O_3$, wherein $0.96 \leq a \leq 1.03$, $0.05 \leq x \leq 0.15$, $0.25 \leq y \leq 0.5$, $0.35 \leq z \leq 0.6$ and $x + y + z = 1$, and $(Pb_{a-b} Me_b)[(Zn_{1/3}Nb_{2/3})_x Ti_y Zr_z]O_3$, wherein $0.96 \leq a \leq 1.03$, $0 < b \leq 0.1$, $0.05 \leq x \leq 0.15$, $0.25 \leq y \leq 0.5$, $0.35 \leq z \leq 0.6$, $x + y + z = 1$ and Me stands for at least one species selected from the group consisting of Sr, Ca and Ba.

5. A piezoelectric ceramic composition according to claim 1, further comprising as a second accessory gradient at least one species selected from the group consisting of Ta, Sb, Nb and W in an amount of 1.0 mass% or less in terms of an oxide.

6. A method for the production of a piezoelectric ceramic composition comprising as a chief ingredient a composite oxide that has Pb, Ti and Zr as constituent elements, comprising the steps of adding at least one additive species selected from the group consisting of Mn, Co, Cr, Fe and Ni to a raw material matrix composition of the composite oxide to obtain a mixture; and
firing the mixture under reducing and firing conditions.

7. A method for the production of a piezoelectric ceramic composition according to claim 6, wherein the reducing and firing conditions comprise a firing temperature in a range of 800°C to 1200°C and an oxygen partial pressure in a range of $1 \times 10^{-10}$ to $1 \times 10^{-6}$ atm.

8. A method for the production of a piezoelectric ceramic composition according to claim 6, further comprising the step of annealing performed after the step of firing.

9. A piezoelectric element comprising:

   a plurality of piezoelectric layers each containing a piezoelectric ceramic composition that comprises as a chief ingredient a composite oxide having Pb, Ti and Zr as constituent elements and as a first accessory ingredient at least one element selected from the group consisting of Mn, Co, Cr, Fe and Ni in an amount of 0.2 mass% or less excluding 0 mass% in terms of an oxide; and
   internal electrodes each intervening between adjacent piezoelectric layers and containing Cu or Ni.

10. A piezoelectric element according to claim 9, wherein it is that fired under reducing and firing conditions.

11. A piezoelectric element according to claim 10, wherein the reducing and firing conditions comprise a firing temperature in a range of 800°C to 1200°C and an oxygen partial pressure in a range of $1 \times 10^{-10}$ to $1 \times 10^{-6}$ atm.

12. A piezoelectric element according to claim 9, wherein the composite oxide is at least one of $Pb_a[(Zn_{1/3}Nb_{2/3})_xTi_yZr_z]O_3$, wherein $0.96 \leq a \leq 1.03$, $0.05 \leq x \leq 0.15$, $0.25 \leq y \leq 0.5$, $0.35 \leq z \leq 0.6$ and $x + y + z = 1$, and $(Pb_{a-b} Me_b)[(Zn_{1/3}Nb_{2/3})_xTi_yZr_z]O_3$, wherein $0.96 \leq a \leq 1.03$, $0 < b \leq 0.1$, $0.05 \leq x \leq 0.15$, $0.25 \leq y \leq 0.5$, $0.35 \leq z \leq 0.6$, $x + y + z = 1$ and Me stands for at least one species selected from the group consisting of Sr, Ca and Ba.

13. A piezoelectric element according to claim 9, wherein the piezoelectric body layers further contain as an accessory ingredient at least one species selected from the group consisting of Ta, Sb, Nb and W in an amount of 1.0 mass% in terms of an oxide.

14. A piezoelectric ceramic composition fired under reducing and firing conditions and comprising:

   as a chief ingredient a composite oxide that has Pb, Ti and Zr as constituent elements; and
   as a first accessory ingredient at least one species selected from ingredients represented by $CuO_x$, wherein $x \geq 0$, in an amount of 3.0 mass% or less excluding 0 mol% in terms of CuO.

15. A piezoelectric ceramic composition according to claim 14, wherein the reducing and firing conditions comprise a firing temperature in a range of 800°C to 1200°C and an oxygen partial pressure in a range of $1 \times 10^{-10}$ to $1 \times 10^{-6}$ atm.

16. A piezoelectric ceramic composition according to claim 14, wherein the composite oxide is at least one of $Pb_a[(Zn_{1/3}Nb_{2/3})_xTi_yZr_z]O_3$, wherein $0.96 \leq a \leq 1.03$, $0.05 \leq x \leq 0.15$, $0.25 \leq y \leq 0.5$, $0.35 \leq z \leq 0.6$ and $x + y + z = 1$, and $(Pb_{a-b} Me_b)[(Zn_{1/3}Nb_{2/3})_xTi_yZr_z]O_3$, wherein $0.96 \leq a \leq 1.03$, $0 < b \leq 0.1$, $0.05 \leq x \leq 0.15$, $0.25 \leq y \leq 0.5$, $0.35 \leq z \leq 0.6$, $x + y + z = 1$ and Me stands for at least one species selected from the group consisting of Sr, Ca and Ba.

17. A piezoelectric ceramic composition according to claim 14, further comprising as a second accessory gradient at least one species selected from the group consisting of Ta, Sb, Nb and W in an amount of 1.0 mass% or less in terms of an oxide.

18. A method for the production of a piezoelectric ceramic composition comprising as a chief ingredient a composite oxide that has Pb, Ti and Zr as constituent elements, comprising the steps of:

   adding an additive species containing Cu to a raw material matrix composition of the composite oxide to obtain a mixture; and
   firing the mixture under reducing and firing conditions.

19. A method for the production of a piezoelectric ceramic composition according to claim 18, wherein the reducing and firing conditions comprise a firing temperature in a range of 800°C to 1200°C and an oxygen partial pressure in a range of $1 \times 10^{-10}$ to $1 \times 10^{-6}$ atm.

20. A method for the production of a piezoelectric ceramic composition according to claim 18, wherein the additive species is at least one species selected from the group consisting of Cu, $Cu_2O$ and CuO.

21. A method for the production of a piezoelectric ceramic composition according to claim 18, further comprising the step of calcination and wherein the step of adding is performed before the step of calcination.

22. A method for the production of a piezoelectric ceramic composition according to claim 18, further comprising the step of calcination and wherein the step of adding is performed after the step of calcination.

23. A piezoelectric element comprising:

   a plurality of piezoelectric body layers each having as a chief ingredient a composite oxide that has Pb, Ti and Zr as constituent elements and containing at least one species selected from ingredients represented by $CuO_x$, wherein $x \geq 0$; and
   internal electrode layers each intervening between adjacent piezoelectric body layers and containing Cu.

24. A piezoelectric element according to claim 23, wherein the $CuO_x$ is in an amount of 3.0 mass% or less excluding 0 mass% in terms of CuO.

25. A piezoelectric element according to claim 23, wherein the $CuO_x$ is that diffused from the internal electrode layers.

26. A piezoelectric element according to claim 23, wherein the $CuO_x$ is that added as an additive to the piezoelectric body layers.

27. A piezoelectric element according to claim 23, wherein it is that fired under reducing and firing conditions.

28. A piezoelectric element according to claim 27, wherein the reducing and firing conditions comprise a firing temperature in a range of 800°C to 1200°C and an oxygen partial pressure in a range of $1 \times 10^{-10}$ to $1 \times 10^{-6}$ atm.

29. A piezoelectric element according to claim 23, wherein the composite oxide is at least one of $Pb_a[(Zn_{1/3}Nb_{2/3})_xTi_yZr_z]O_3$, wherein $0.96 \leq a \leq 1.03$, $0.05 \leq x \leq 0.15$, $0.25 \leq y \leq 0.5$, $0.35 \leq z \leq 0.6$ and $x + y + z = 1$, and $(Pb_{a-b} Me_b)[(Zn_{1/3}Nb_{2/3})_xTi_yZr_z]O_3$, wherein $0.96 \leq a \leq 1.03$, $0 < b \leq 0.1$, $0.05 \leq x \leq 0.15$, $0.25 \leq y \leq 0.5$, $0.35 \leq z \leq 0.6$, $x + y + z = 1$ and Me stands for at least one species selected from the group consisting of Sr, Ca and Ba.

30. A piezoelectric element according to claim 23, wherein the piezoelectric body layers further contain as an accessory ingredient at least one species selected from the group consisting of Ta, Sb, Nb and W in an amount of 1.0 mass% in terms of an oxide.

31. A method for the production of a piezoelectric element comprising a plurality of piezoelectric body layers each having as a chief ingredient a composite oxide that has Pb, Ti and Zr as constituent elements and internal electrode layers each intervening between adjacent piezoelectric body layers and containing Cu, comprising the step of sintering under reducing and firing conditions to diffuse the Cu contained in the internal electrode layers into the piezoelectric body layers.

32. A method for the production of a piezoelectric element according to claim 31, wherein the reducing and firing conditions comprise a firing temperature in a range of 800°C to 1200°C and an oxygen partial pressure in a range of $1 \times 10^{-10}$ to $1 \times 10^{-6}$ atm.

33. A method for the production of a piezoelectric element comprising a plurality of piezoelectric body layers each having as a chief ingredient a composite oxide that has Pb, Ti and Zr as constituent elements and internal electrode layers each intervening between adjacent piezoelectric body layers and containing Cu, comprising the steps of:

   adding an additive species containing Cu to a raw material matrix composition of the piezoelectric body layers to obtain a mixture; and
   firing the mixture under reducing and firing conditions.

**34.** A method for the production of a piezoelectric element according to claim 33, wherein the reducing and firing conditions comprise a firing temperature in a range of 800°C to 1200°C and an oxygen partial pressure in a range of $1 \times 10^{-10}$ to $1 \times 10^{-6}$ atm.

**35.** A piezoelectric ceramic composition containing a composite oxide that has Pb, Ti and Zr as constituent elements and having a structure that has Cu distributed unevenly in grain boundaries.

**36.** A piezoelectric ceramic composition according to claim 35, wherein it is that fired under reducing and firing conditions.

**37.** A piezoelectric ceramic composition according to claim 36, wherein the reducing and firing conditions comprise a firing temperature in a range of 800°C to 1200°C and an oxygen partial pressure in a range of $1 \times 10^{-10}$ to $1 \times 10^{-6}$ atm.

**38.** A piezoelectric ceramic composition according to claim 35, wherein the composite oxide is at least one of $Pb_a[(Zn_{1/3}Nb_{2/3})_xTi_yZr_z]O_3$; wherein $0.96 \leq a \leq 1.03$, $0.05 \leq x \leq 0.15$, $0.25 \leq y \leq 0.5$, $0.35 \leq z \leq 0.6$ and $x + y + z = 1$, and $(Pb_{a-b} Me_b)[(Zn_{1/3}Nb_{2/3})_xTi_yZr_z]O_3$, wherein $0.96 \leq a \leq 1.03$, $0 < b \leq 0.1$, $0.05 \leq x \leq 0.15$, $0.25 \leq y \leq 0.5$, $0.35 \leq z \leq 0.6$, $x + y + z = 1$ and Me stands for at least one species selected from the group consisting of Sr, Ca and Ba.

**39.** A piezoelectric element according to claim 35, wherein the piezoelectric body layers further contain as an accessory ingredient at least one species selected from the group consisting of Ta, Sb, Nb and W in an amount of 1.0 mass% in terms of an oxide.

**40.** A piezoelectric element comprising a plurality of piezoelectric body layers each formed of a piezoelectric ceramic composition containing a composite oxide that has Pb, Ti and Zr as constituent elements and having a structure that has Cu distributed unevenly in grain boundaries, and internal electrode layers each intervening between adjacent piezoelectric body layers and containing Cu.

**41.** A piezoelectric element according to claim 40, wherein it is that fired under reducing and firing conditions.

**42.** A piezoelectric element according to claim 41, wherein the reducing and firing conditions comprise a firing temperature in a range of 800°C to 1200°C and an oxygen partial pressure in a range of $1 \times 10^{-10}$ to $1 \times 10^{-6}$ atm.

**43.** A piezoelectric element according to claim 40, wherein the composite oxide is at least one of $Pb_a[(Zn_{1/3}Nb_{2/3})_xTi_yZr_z]O_3$, wherein $0.96 \leq a \leq 1.03$, $0.05 \leq x \leq 0.15$, $0.25 \leq y \leq 0.5$, $0.35 \leq z \leq 0.6$ and $x + y + z = 1$, and $(Pb_{a-b} Meb)[(Zn_{1/3}Nb_{2/3})_xTi_yZr_z]O_3$, wherein $0.96 \leq a \leq 1.03$, $0 < b \leq 0.1$, $0.05 \leq x \leq 0.15$, $0.25 \leq y \leq 0.5$, $0.35 \leq z \leq 0.6$, $x + y + z = 1$ and Me stands for at least one species selected from the group consisting of Sr, Ca and Ba.

**44.** A piezoelectric element according to claim 40, wherein the piezoelectric body layers further contain as an accessory ingredient at least one species selected from the group consisting of Ta, Sb, Nb and W in an amount of 1.0 mass% in terms of an oxide.

【Fig1】

【Fig2】

【Fig3】

【Fig4】

【Fig5】

【Fig6】

【Fig7】

【Fig8】

【Fig9】

【Fig10】

【Fig11】

0.5 µm

**European Patent Office**

# EUROPEAN SEARCH REPORT

Application Number

EP 06 25 1240

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| D,X | PATENT ABSTRACTS OF JAPAN vol. 2003, no. 12, 5 December 2003 (2003-12-05) & JP 2004 137106 A (TDK CORP), 13 May 2004 (2004-05-13) * abstract * | 1,4,5,9, 12-14, 16,23, 29,30 | INV. C04B35/493 H01L41/08 |
| Y | PATENT ABSTRACTS OF JAPAN vol. 2003, no. 12, 5 December 2003 (2003-12-05) & JP 2003 335579 A (SUMITOMO METAL IND LTD), 25 November 2003 (2003-11-25) * abstract * | 1 | |
| Y | DATABASE WPI Section Ch, Week 198529 Derwent Publications Ltd., London, GB; Class L03, AN 1985-174500 XP002385258 & JP 60 103079 A (SUMITOMO SPECIAL METALS CO LTD) 7 June 1985 (1985-06-07) * abstract * | 1,5 | |
| Y | DATABASE WPI Section Ch, Week 199132 Derwent Publications Ltd., London, GB; Class L02, AN 1991-233272 XP002385259 & JP 03 150265 A (MATSUSHITA ELEC IND CO LTD) 26 June 1991 (1991-06-26) * abstract * | 1,4,5 | **TECHNICAL FIELDS SEARCHED (IPC)** C04B |
| Y | PATENT ABSTRACTS OF JAPAN vol. 2000, no. 24, 11 May 2001 (2001-05-11) & JP 2001 181036 A (TDK CORP), 3 July 2001 (2001-07-03) * abstract * | 1,4,5 | |

-/--

The present search report has been drawn up for all claims

| Place of search | Date of completion of the search | Examiner |
|---|---|---|
| Munich | 14 June 2006 | Vathilakis, S |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

**European Patent Office**

# EUROPEAN SEARCH REPORT

Application Number

EP 06 25 1240

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | PATENT ABSTRACTS OF JAPAN vol. 015, no. 373 (C-0869), 19 September 1991 (1991-09-19) & JP 03 150265 A (MATSUSHITA ELECTRIC IND CO LTD), 26 June 1991 (1991-06-26) * abstract * ----- | 1,4,14 | |
| Y | US 2004/021399 A1 (OGAWA TOMOYUKI ET AL) 5 February 2004 (2004-02-05) * abstract * ----- | 1,4 | |
| A | US 6 080 328 A (HORIKAWA ET AL) 27 June 2000 (2000-06-27) * the whole document * ----- | 9-13, 23-30, 39,40 | |
| X | EP 1 367 036 A (TDK CORPORATION) 3 December 2003 (2003-12-03) * claims 10,6,8 * ----- | 1,14 | |
| | | | TECHNICAL FIELDS SEARCHED (IPC) |

The present search report has been drawn up for all claims

| Place of search | Date of completion of the search | Examiner |
|---|---|---|
| Munich | 14 June 2006 | Vathilakis, S |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 06 25 1240

This annex lists the patent family members relating to the patent documents cited in the above-mentioned European search report.
The members are as contained in the European Patent Office EDP file on
The European Patent Office is in no way liable for these particulars which are merely given for the purpose of information.

14-06-2006

| Patent document cited in search report | | Publication date | Patent family member(s) | | Publication date |
|---|---|---|---|---|---|
| JP 2004137106 | A | 13-05-2004 | NONE | | |
| JP 2003335579 | A | 25-11-2003 | NONE | | |
| JP 60103079 | A | 07-06-1985 | JP | 1007032 B | 07-02-1989 |
| | | | JP | 1526513 C | 30-10-1989 |
| JP 3150265 | A | 26-06-1991 | JP | 2884631 B2 | 19-04-1999 |
| JP 2001181036 | A | 03-07-2001 | JP | 3468461 B2 | 17-11-2003 |
| JP 03150265 | A | 26-06-1991 | JP | 2884631 B2 | 19-04-1999 |
| US 2004021399 | A1 | 05-02-2004 | CN | 1473793 A | 11-02-2004 |
| | | | CN | 1680212 A | 12-10-2005 |
| | | | JP | 2004059335 A | 26-02-2004 |
| US 6080328 | A | 27-06-2000 | CN | 1237799 A | 08-12-1999 |
| | | | DE | 19916380 A1 | 14-10-1999 |
| | | | JP | 3341672 B2 | 05-11-2002 |
| | | | JP | 11292625 A | 26-10-1999 |
| | | | TW | 461127 B | 21-10-2001 |
| EP 1367036 | A | 03-12-2003 | CN | 1475457 A | 18-02-2004 |
| | | | JP | 2004002069 A | 08-01-2004 |
| | | | US | 2003222240 A1 | 04-12-2003 |

EPO FORM P0459

For more details about this annex : see Official Journal of the European Patent Office, No. 12/82

**REFERENCES CITED IN THE DESCRIPTION**

**Patent documents cited in the description**

- JP 2004137106 A